(19) Europäisches Patentamt
European Patent Office
Office européen des brevets

(11) **EP 4 014 053 B1**

(12) **EUROPÄISCHE PATENTSCHRIFT**

(45) Veröffentlichungstag und Bekanntmachung des Hinweises auf die Patenterteilung:
**06.03.2024   Patentblatt 2024/10**

(21) Anmeldenummer: **20737015.6**

(22) Anmeldetag: **07.07.2020**

(51) Internationale Patentklassifikation (IPC):
*G01R 33/07* (2006.01)    *G01R 33/00* (2006.01)
*B41F 13/00* (2006.01)    *B41K 3/10* (2006.01)
*B41F 33/00* (2006.01)    *B41J 7/96* (2006.01)
*B41K 3/12* (2006.01)

(52) Gemeinsame Patentklassifikation (CPC):
**B41K 3/127; B41F 13/0032; B41F 13/0045;**
**B41F 33/009; B41J 7/96; B41K 3/125;**
G01R 33/0094; G01R 33/07

(86) Internationale Anmeldenummer:
**PCT/EP2020/069090**

(87) Internationale Veröffentlichungsnummer:
**WO 2021/028122 (18.02.2021 Gazette 2021/07)**

(54) **VORRICHTUNGEN ZUR ALPHANUMERISCHEN KENNZEICHNUNG VON DRUCKPRODUKTEN SOWIE WERTPAPIERDRUCKMASCHINE**

DEVICES FOR THE ALPHANUMERIC LABELLING OF PRINTED PRODUCTS, AS WELL AS A SECURITY PAPER PRINTING MACHINE

DISPOSITIFS D'IDENTIFICATION ALPHANUMÉRIQUE DE PRODUITS IMPRIMÉS, ET MACHINE D'IMPRESSION DE PAPIER FIDUCIAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.08.2019   DE 102019121780**
**13.08.2019   DE 102019121779**
**13.08.2019   DE 102019121778**

(43) Veröffentlichungstag der Anmeldung:
**22.06.2022   Patentblatt 2022/25**

(73) Patentinhaber: **Koenig & Bauer AG**
**97080 Würzburg (DE)**

(72) Erfinder:
• **BLESS, Stefan**
**32756 Detmold (DE)**

• **DIEDERICHS, Carsten**
**32657 Lemgo (DE)**
• **MERMINOD, Antoine**
**1188 Gimel (CH)**

(74) Vertreter: **Koenig & Bauer AG**
**- Lizenzen - Patente -**
**Friedrich-Koenig-Straße 4**
**97080 Würzburg (DE)**

(56) Entgegenhaltungen:
**AU-B2- 2013 209 308      CN-A- 109 591 442**
**ES-T3- 2 357 985        JP-A- 2006 224 519**
**JP-A- 2016 175 278       US-A1- 2003 069 860**

**Beschreibung**

Die Erfindung betrifft eine Vorrichtung zur alphanumerischen Kennzeichnung von Wertpapieren gemäß dem Oberbegriff des Anspruches 1 sowie eine Wertpapierdruckmaschine gemäß Anspruch 14.

Durch die WO 2007/148288 A2 sowie durch die ES 2 357 985 T3 und die AU 2013 209 308 B2 ist eine Vorrichtung und ein Verfahren zur alphanumerischen Kennzeichnung von Druckprodukten bekannt, wobei einzelne Nummerierräder mechanisch unabhängig voneinander durch eigene Antriebsmotoren, insbesondere bürstenlose Gleichstrommotoren, angetrieben sind. Jedes eine Mehrzahl von alphanummerische Zeichen tragende Nummerierrad trägt am Außenumfang zum Zwecke eines Kalibrierens zusätzlich einen Magneten, der durch z. B. einen Hall-Sensor detektierbar ist. Zusätzlich ist ein Verriegelungselement vorgesehen, welches zur Sicherung der eingestellten Lage von innen her durch Federkraft in eine Nut im Innenumfang des Nummerierrades gedrückt und durch Beaufschlagung einer Spule mit elektrischem Strom über Reluktanzkräfte aus der Nut heraus bewegt wird.

In der JP 2004-160788 werden Nummerierräder durch biaxiale Schrittmotoren angetrieben, wobei die Winkelstellungen über Magnete detektiert werden, welche sich am Außenumfang von Zwischenzahnrädern des jeweiligen Antriebsstranges befinden und durch Magnetsensoren detektiert werden. Ein kammartiges Verriegelungselement greift zwischen die Zähne von mit den Nummerierrädern verbundenen Zahnrädern ein. Es wird durch Aktivieren eines Solenoiden angestellt und bei Deaktivierung des Solenoiden durch Federkraft abgestellt.

Die WO 2016/000741 A1 offenbart eine Vorrichtung und ein Verfahren zur alphanumerischen Kennzeichnung von Druckprodukten, wobei einzelne Nummerierräder durch Schritt- oder bürstenlose Gleichstrommotoren angetrieben werden. Das Nummerierrad trägt am Außenumfang zwischen den Zeichen angeordnete Markierungen, insbesondere Magneten, die durch Sensoren, z. B. Hall-Sensoren detektierbar sind. Zusätzlich trägt der Motor einen Encoder, mittels dessen die Bewegung der Motorachse überwacht werden kann. Hierzu ist eine Überwachungselektronik vorgesehen, welche in Signalkommunikation sowohl mit dem Encoder als auch mit einem am Nummerierrad vorgesehenen Sensor steht und die die Positionierung der Räder überwacht, indem sie anhand einer Tabelle Zählerstände am Encoder beim Durchgang einer Markierung mit für den Durchgang zu erwartenden Soll-Zählerzuständen vergleicht.

Die DE 38 41 231 A1 betrifft eine Codiervorrichtung für Typen- oder Druckräder, insbesondere an Frankiermaschinen. Dabei ist in einer Ausführung eine Lage des Typenrades durch die Signalhöhe eines Hallsensors charakterisiert, der in einer festen Achse innerhalb des sich drehenden Typenrades angeordnet ist. Dabei verläuft der Innenumfang des Typenrades nicht mit konstantem Radius, sondern spiralförmig mit variierendem Abstand zur Achse. In einer Weiterbildung können korreliert zu den Typen am Umfang einzelne Zähne mit entlang einer spiralförmiger Linie variierender Zahnhöhe vorgesehen sein. Bei Betrieb des Typenrades und dem Einstellen einer bestimmten Type wird während des Drehens der am Ausgang des Sensors vorliegende Wert mit dem zuvor durch einen Referenzierungslauf erhaltenen Sollwert für das Signal verglichen. Bei Erreichen der gewünschten Position wird zur Einstellung des nächsten Typenrades übergegangen oder zurück zum Hauptprogramm.

Durch die GB 2 243 580 A ist eine Überwachungseinrichtungen zur Überwachung der Lage von Markierungszeichen offenbart, wobei ein resultierendes Magnetfeld eines stationären achsfesten Magneten und ein oder mehrerer am Umfang des Zeichenrades vorgesehener Magnete am Umfang des Zeichenrades in einem Winkelabstand von 90° erfasst und zur Ermittlung der Lage herangezogen wird.

Die WO 2017/157619 A1 offenbart neben einem Siebdruckwerk und einem Offsetdruckwerk ein Nummerierdruckwerk, welches am Umfang eine Mehrzahl von in Reihen und Spalten angeordnete Nummereinrichtungen trägt.

Die JP 2006-224519 A betrifft ein Nummerierwerk, deren Nummerierräder mechanisch über einen Zahnradzug durch die Drehbewegung des Zylinders angetrieben ist. Dabei sitzen die Nummerierräder auf einer rotierenden Achse und werden in der für das gewünschte Zeichen erforderlichen Lage durch Einrasten eines Nockens festgehalten. Der Nocken wird über einen Magneten in die Halteposition verbracht.

Der Erfindung liegt die Aufgabe zugrunde, Vorrichtung zur alphanumerischen Kennzeichnung von Wertpapieren und eine Wertpapierdruckmaschine zu schaffen.

Die Aufgabe wird erfindungsgemäß durch die Merkmale der Anspruches 1 bzw. 14 gelöst.

Die mit der Erfindung erzielbaren Vorteile bestehen insbesondere darin, dass ein besonders zuverlässiges und/oder sicheres Einstellen des bzw. der zu druckenden Zeichen ermöglicht wird und/oder darin, dass der technische Aufwand, z. B. im Bereich der sich drehenden Teile und/oder an zusätzlichen elektrischen Bauteilen gering gehalten wird.

Durch eine bevorzugte Ausführung des Motors als Schrittmotor ist z. B. eine Ansteuerung von Motorpositionen vereinfacht möglich. Im Zusammenspiel mit einer zusätzlichen Sensoreinrichtung, durch welche beim Drehen die Zeichen erforderliche Lagen des Kennzeichnungswerkzeuges detektierbar sind, ist ein genaues Referenzieren und/oder eine Überprüfung im Betrieb durchführbar. Für letztere erfolgt z. B. während des Anfahrens oder bei Erreichen einer für ein Zeichen bzw. Feld vorgegebenen Zielschrittzahl anhand der Signale aus der Sensoreinrichtung eine Überprüfung dahingehend, ob und/oder in welcher Güte in der Zielposition eine Marke vorliegt oder nicht.

Eine besonders geeignete Vorrichtung zur alphanumerischen Kennzeichnung von Druckprodukten umfasst beispielsweise eine in einem Gestell gelagerte Achse, um welche mindestens ein rad- oder ringförmiges Kennzeichnungswerkzeug drehbar gelagert ist, welches an seinem Außenumfang hintereinander mehrere, d. h. eine Anzahl alphanummerische Zeichen trägt, und Antriebsmittel mit einem als Schrittmotor ausgebildeten Antriebsmotor, durch welche das Kennzeichnungswerkzeug um die Achse rotierbar ist. Bevorzugt steht der Antriebsmotor in Signalverbindung zu Datenverarbeitungs- und/oder Speichermitteln einer Steuerungseinrichtung, in welchen eine Zuordnungsvorschrift zwischen den Arbeitspositionen der alphanummerischen Zeichen und Schrittzahlen des Schrittmotors vorgehalten ist, wobei der Antriebsmotor zur Überführung eines zu druckenden Zeichens in eine Arbeitsposition durch die Steuereinrichtung unter Anwendung dieser vorgehaltenen Zuordnungsvorschrift hinsichtlich einer zurückzulegenden Schrittanzahl, und in bevorzugter Ausführung zusätzlich hinsichtlich der Schrittrichtung steuerbar oder gesteuert ist. Dabei ist die Steuereinrichtung oder eine von der Steuereinrichtung umfasste und/oder in dieser implementierte Steuerroutine vorzugsweise ausgeführt, ausgehend von einer bestimmten oder aktuellen Schrittstellung des Schrittmotors bzw. des Nummerierrades und einer für diese Stellung bekannten Schrittzahl eine für das nachfolgend einzustellende Zeichen bzw. Feld anhand der Zuordnungsvorschrift eine für dieses Zeichen bzw. Feld relevante Schrittzahl zu bestimmen, aus der Differenz eine durch den Schrittmotor zurückzulegende Schrittanzahl zu ermitteln, und den Antriebsmotor entsprechend der ermittelten Schrittanzahl anzusteuern.

Der Ausdruck Schrittzahl ist hier im Sinne einer individualisierten Schrittnummer zu verstehen, wohingegen der Ausdruck Schrittanzahl eine bestimmte Anzahl von Schritten meint.

Vorzugsweise erfolgt die alphanumerische Kennzeichnung von Druckprodukten indem ein Kennzeichnen eines Druckproduktes mit mindestens einem alphanummerischen Zeichen durch direktes oder indirektes Bedrucken eines Bedruckstoffs durch mindestens ein ringförmiges, um eine Achse drehbar gelagertes und in Umfangsrichtung hintereinander mehrere, d. h. eine Anzahl alphanummerische Zeichen tragendes Kennzeichnungswerkzeug erfolgt, eine Positioniererg eines zu druckenden Zeichens in eine Arbeitsposition durch ein Verdrehen des Kennzeichnungswerkzeuges um eine das Kennzeichnungswerkzeug drehbar lagernde Achse erfolgt, das Verdrehen durch einen als Schrittmotor ausgebildeten Antriebsmotor bewirkt wird, wobei das Verdrehen des Kennzeichnungswerkzeuges zur Positionierung des zu druckenden Zeichens durch den Antriebsmotor unter Anwendung einer hinterlegten Zuordnungsvorschrift zwischen den Arbeitspositionen der alphanummerische Zeichen und Schrittzahlen des Schrittmotors erfolgt. Dabei wird bevorzugter Weise ausgehend von einer bestimmten Schrittstellung des Schrittmotors oder des Nummerierrades und einer für diese Stellung bekannten Schrittzahl eine für das nachfolgend einzustellende Zeichen bzw. anhand der Zuordnungsvorschrift eine für dieses Zeichen bzw. Feld relevante bestimmt und aus der Differenz eine durch den Schrittmotor zurückzulegende Schrittanzahl ermittelt und der Antriebsmotor entsprechend der ermittelten Schrittanzahl angesteuert wird

Indem, unabhängig von obigem Aspekt oder auch vorteilhaft zusätzlich hierzu, in einer zu bevorzugenden Ausführung ein Verriegelungselement nicht oder nicht allein durch Federkraft, sondern aktiv durch einen stabilen Aktuatorzustand in der Verriegelungslage gehalten wird, ist ein unbeabsichtigtes Verdrehen weiter gehemmt. Ein sicheres Abheben ist dabei durch wenigstens einen weiteren aktiven Aktuatorzustand gewährleistet.

Hierzu umfasst eine geeignete Vorrichtung zur alphanumerischen Kennzeichnung von Wertpapieren beispielsweise eine in einem Gestell gelagerte Achse, um welche mindestens ein rad- oder ringförmiges, an seinem Außenumfang hintereinander mehrere, d. h. eine Anzahl alphanummerische Zeichen tragendes Kennzeichnungswerkzeug drehbar gelagert ist, Antriebsmittel, durch welche das mindestens eine Kennzeichnungswerkzeug um die Achse rotierbar um eines der Zeichen in einer Arbeitsposition zu positionieren, und ein Verriegelungsmittel zur Sicherung der für das gewählte Zeichen eingenommenen Arbeitsposition, welches durch einen Aktuator aus einer aktiven Lage, in der er die Arbeitsposition sichert, in eine inaktiven Lage verbringbar ist. In bevorzugter Ausführung ist der Aktuator hierbei als elektromechanisch betätigtes Antriebsmittel ausgebildet ist, welches infolge unterschiedlicher Ansteuerung mit seinem ausgangsseitigen Abtriebselement wahlweise in mindestens zwei verschiedene, die aktive und die inaktive Lage des Verriegelungselementes bewirkende definierte Schaltzustände verbringbar ist. Bevorzugter Weise ist der Aktuator dergestalt, dass durch ihn in den beiden Schaltzuständen das mittel- oder unmittelbar auf das Verriegelungselement wirkende Abtriebselement mit in je entgegengesetzt zueinander wirkenden Kräften beaufschlagt bzw. beaufschlagbar ist. So ist sichergestellt, dass sowohl in aktiver, also Verriegelungslage als auch in inaktiver, also unwirksamer Lage eine durch den Aktuator beaufschlagte und in die jeweilige Richtung wirkende Kraft anliegt.

In einer weiteren zu bevorzugenden Ausführung, unabhängig oder vorteilhaft zusätzlich zu einem oder mehreren der obigen Aspekte, ist eine Sensoreinrichtung vorgesehen, welche für ein oder jedes einzelmotorisch zu positionierendes Nummerrierrad zwei oder mehr Sensoren umfasst, deren Signale neben der Detektion eines Markendurchganges auch die Ermittlung der Bewegungsrichtung erlauben und/oder welche achsfest vorgesehen und hierdurch beispielsweise besonders geschützt vor Verschmutzung oder Beschädigung und/oder z. B. bei der Zugänglichkeit der Räder nicht im Wege ist.

Dabei umfasst eine geeignete Vorrichtung zur alphanumerischen Kennzeichnung von Wertpapieren beispielsweise eine in einem Gestell gelagerte Achse, um welche eine Mehrzahl von rad- oder ringförmigen, an ihrem Außenumfang hintereinander mehrere, d. h. eine Anzahl alphanummerische Zeichen tragende Kennzeichnungswerkzeuge drehbar gelagert ist, Antriebsmittel mit je einem Antriebsmotor für mehrere oder jedes der Mehrzahl von Kennzeichnungswerkzeugen, durch welche diese mechanisch unabhängig voneinander um die Achse rotierbar sind, und eine Sensoreinrichtung mit mindestens je einem im Betrieb gestellfesten Sensor für jedes der Mehrzahl von Kennzeichnungswerkzeugen, welche jeweils mit mindestens einer der Anzahl der alphanummerische Zeichen entsprechenden Anzahl von für die Wirkungsweise des Sensors spezifischen Marken zusammenwirken, die am jeweiligen Kennzeichnungswerkzeug in je einer festen Umfangsrelativlage zu je einem am Außenumfang getragenen Zeichen vorgesehen sind. In einer oben genannten bevorzugter Ausführung sind für ein oder jedes einzelmotorisch zu positionierende Nummerrierrad mindestens zwei, bevorzugt in Umfangsrichtung versetzte Sensoren vorgesehen und/oder die Sensoren im Betrieb achsfest und innerhalb des lichten Querschnitts von die Achse aufnehmenden Öffnungen der Kennzeichnungswerkzeuge angeordnet und die Marken im Bereich des in der Öffnung verlaufenden Innenumfangs der betreffenden Kennzeichnungswerkzeuge vorgesehen.

Ausführungsbeispiele der Erfindung sind in den Zeichnungen dargestellt und werden im Folgenden näher beschrieben.

Es zeigen:

Fig. 1      ein schematisches Ausführungsbeispiel für ein Druckwerk zur alphanumerischen Kennzeichnung von Druckprodukten;

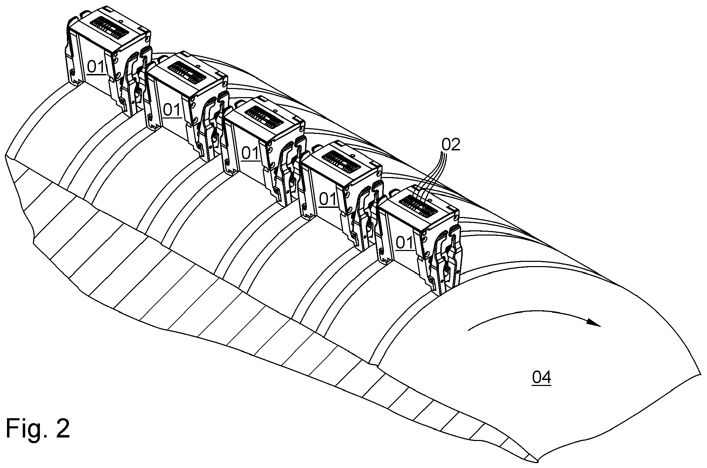

Fig. 2      ein Ausführungsbeispiel für die Anordnung einer Reihe von Kennzeichnungsvorrichtungen am Umfang eines Druckwerkszylinders;

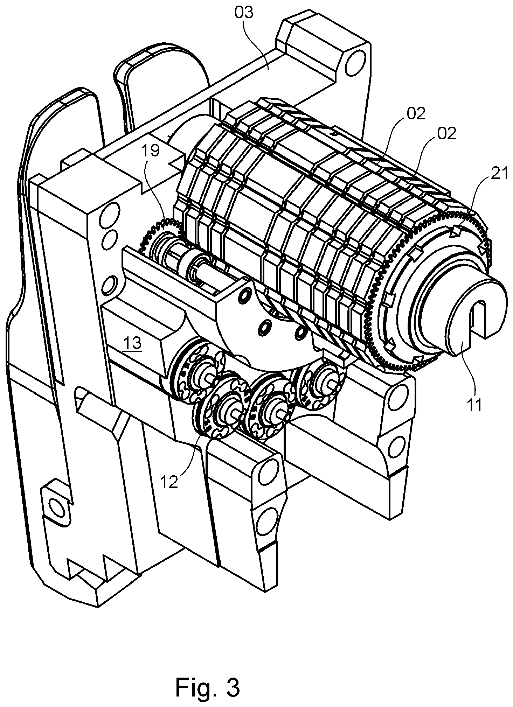

Fig. 3      ein einseitig geöffnete Darstellung eines Ausführungsbeispiel für eine Kennzeichnungsvorrichtung;

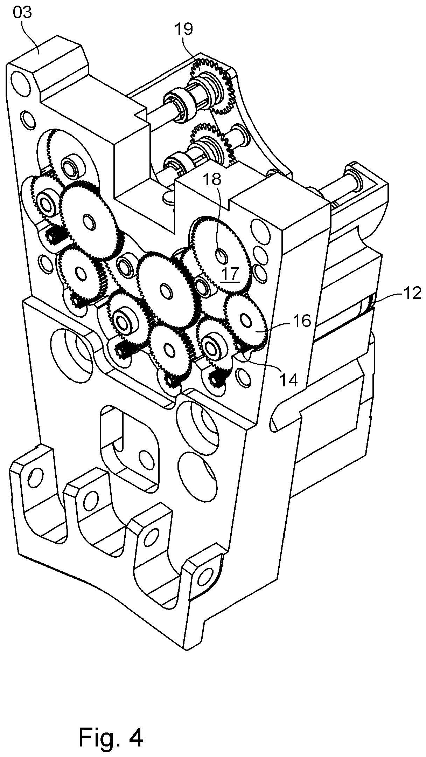

Fig. 4      eine Darstellung des Ausführungsbeispiels aus Fig. 3 von der anderen Seite;

Fig. 5      eine schematische Darstellung einer ein Kennzeichnungsrad tragenden Achse einer Kennzeichnungsvorrichtung;

Fig. 6      eine schematische Prinzipdarstellung für die Signalfolgen aus zwei Sensoren gemäß einer Ausführung der Sensoreinrichtung gemäß Fig. 5;

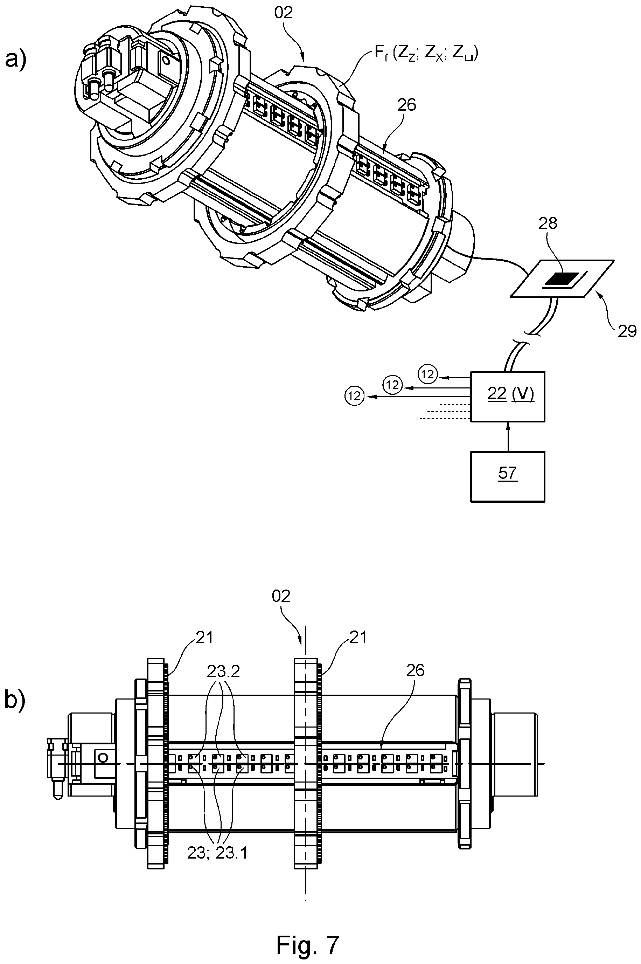

Fig. 7      eine perspektivische Darstellung a) und eine schematische Seitenansicht b) einer Achse mit exemplarischen Kennzeichnungsringen und einer Anordnung von Sensoren;

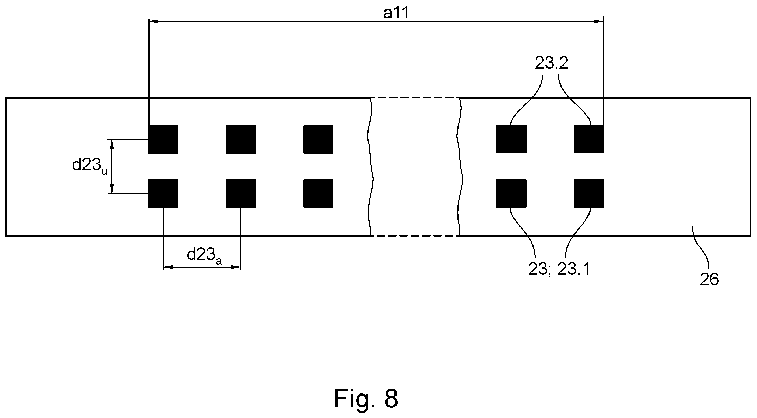

Fig. 8      eine schematische Darstellung für ein Ausführungsbeispiel der Sensoreinrichtung mit einer gegenüber der Anzahl von Kennzeichnungsrädern größeren Anzahl nebeneinander angeordneter Sensoren;

Fig. 9      eine schematische Darstellung für ein Ausführungsbeispiel der Sensoreinrichtung mit einer Anzahl von Sensorarrays;

Fig. 10      eine schematische Darstellung für den Signalverlauf an einem Sensor in Abhängigkeit von der Schrittzahl am Motor bei einer vollen Umdrehung des Kennzeichnungsrades um 360°;

Fig. 11      eine schematische Darstellung für die Zuordnung zwischen den Positionen der Markierungen und Schrittzahl nach Auswertung des Signalverlaufs aus Fig. 10;

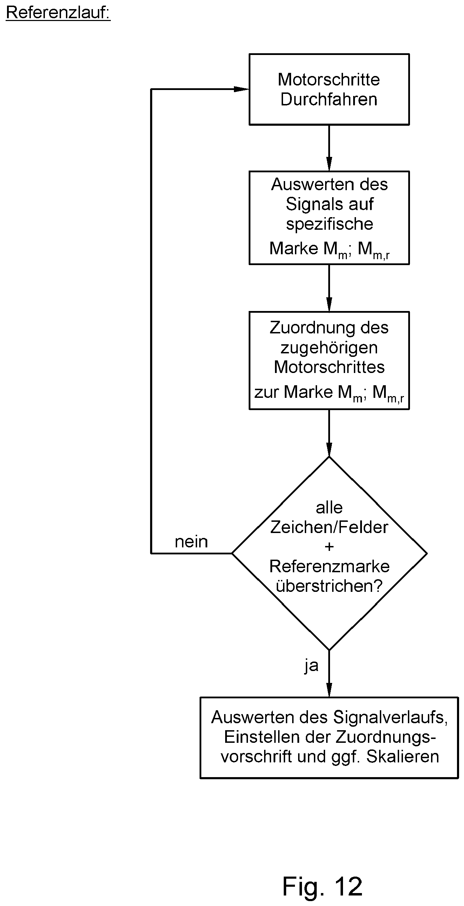

Fig. 12      eine Verfahrensflussbild für die Erzeugung des Zusammenhanges zwischen den einzelnen Felder bzw. Zeichen und Schrittzahlen des Schrittmotors während eines Referenzierungslaufs;

Fig. 13      eine Verfahrensflussbild für das Anfahrten von einzustellenden Feldern unter Verwendung des Zusammenhanges zwischen den die Felder und den Schrittzahlen des Schrittmotors im Betrieb;

Fig. 14      ein Ausführungsbeispiel für den Antrieb eines Verriegelungsmittels in erster Ausführungsform durch einen rotierenden Aktuator mit mehreren definierten Schaltzuständen a) in Schnittansicht längs der Achse und b) in Schnittansicht senkrecht der Achse

Fig. 15      eine erste Ausführungsvariante einer zweiten Ausführungsform für den Antrieb des Verriegelungsmittels durch einen linearen Aktuator mit mehreren definierten Schaltzuständen;

Fig. 16      eine zweite Ausführungsvariante für die zweite Ausgestaltung des Antriebes des Verriegelungsmittels durch einen linearen Aktuator mit mehreren definierten Schaltzuständen.

Eine Vorrichtung 01 zur alphanumerischen Kennzeichnung von Druckprodukten, insbesondere von Wertpapieren, umfasst mindestens ein, bevorzugt nebeneinander mehrere, z. B. eine Anzahl p (

$$p \in \mathbb{N},$$

p > 1) rad- oder ringförmige Kennzeichnungswerkzeuge 02, welche um eine in einem Gestell 03 und/oder Gehäuse 03 gelagerte Achse 11 drehbar gelagert sind. Vorzugsweise sind mindestens sechs, beispielsweise sogar mindestens zwölf derartige Kennzeichnungswerkzeuge 02 nebeneinander angeordnet.

Auf ihrem Außenumfang tragen die Kennzeichnungswerkzeuge 02 hintereinander Druckvorlagen mehrerer, d. h. einer Anzahl k (

$$k \in \mathbb{N},$$

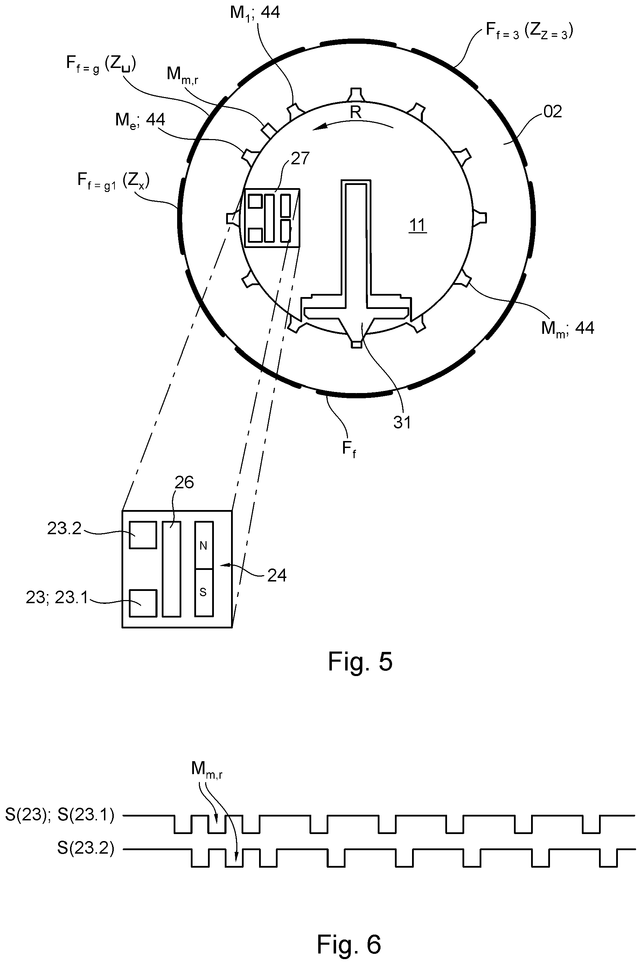

k > 1) alphanummerische Zeichen Zz (mit z aus {1, 2, ...k}). Obgleich es sich streng genommen um deren Druckvorlagen handelt, wird im Folgenden der Einfachheit halber verkürzt auf "Zeichen $Z_Z$" Bezug genommen. Die Zeichen $Z_Z$ befinden sich in Winkelsegmenten des Kennzeichnungswerkzeuges 02, wobei nicht in jedem Winkelsegment ein Zeichen Zz vorgesehen sein muss. So sind beispielsweise k Felder $F_f$ (mit f aus {1, 2, ...g},

$$g \in \mathbb{N},$$

g ≥ k), d. h. für das Drucken vorgesehene Umfangsabschnitte, mit k alphanummerische Zeichen $Z_Z$ vorgesehen, wobei zusätzlich ein Feld $F_f$ ohne Zeichen, z. B. Leerfeld, für ein Leerzeichen $Z_\_$ und/oder ein Feld $F_f$ mit einem als Sonderzeichen oder Symbol ausgebildeten Zeichen $Z_X$ vorgesehen sein kann, welches beispielsweise zur Kennzeichnung eines Fehldruckes, d. h. beispielsweise eines Nutzens unzulässig schlechter Qualität, dient. Es können beispielsweise 12 Felder $F_f$ am Umfang vorgesehen sein, wobei z. B. Felder $F_f$ für die alphanumerische Zeichen $Z_Z$ der Ziffern 0 bis 9, ein Leerfeld für ein fehlendes Zeichen $Z_\_$, z. B. Leerzeichen $Z_\_$ und/oder ein der Fehldruckkennzeichnung dienendes Zeichen $Z_X$, z. B. Fehlerzeichen $Z_X$ bzw. -symbol vorgesehen ist (z. B. in Fig. 5 beispielhaft mit neun Feldern $F_f$ mit den alphanummerischen Zeichen $Z_Z$ der Ziffern 0 bis 9, z. B. exemplarisch bezeichnet das Feld $F_{f=3}$, ein Feld $F_f$ für ein Fehlerzeichen $Z_x$, hier z. B. Feld $F_{f=g-1}$, und ein Feld $F_f$ ohne Zeichen, also ein Leerzeichens $Z_\_$, hier z. B. Feld $F_{f=g}$.

Die Kennzeichnungswerkzeuge 02 werden unabhängig davon, ob sie nur nummerische Zeichen $Z_Z$ tragen oder nicht, im Folgenden auch als "Nummerierräder" 02 bezeichnet. Zusätzlich zu den p Kennzeichnungswerkzeugen 02 können auch ein oder mehrere solche rad- oder ringförmigen Elemente vorgesehen sein, die zwar baulich den Kennzeichnungswerkzeugen 02 entsprechen, jedoch keine Zeichen $Z_Z$ am Umfang tragen und lediglich dem Auffüllen von Leerplätzen in der Zeichenfolge oder dem Ausgleich eines Untermaßes dienen.

Derartiger Vorrichtungen 01 zur alphanumerischen Kennzeichnung von Druckprodukten, kurz Kennzeichnungsvorrichtungen 01 bzw. Nummeriervorrichtungen 01, können grundsätzlich zwar in beliebigen Kennzeichnungsmaschinen vorgesehen sein, finden hier jedoch bevorzugt Anwendung beim Kennzeichnen von Wertpapiernutzen in einem Druckwerk 04 einer Druckmaschine, bevorzugt Rotationsdruckmaschine, insbesondere Wertpapierdruckmaschine. Eine solche umfasst beispielsweise eine eingangsseitige Bedruckstoffzufuhr, durch welche der Druckmaschine eingangsseitig der zu bedruckende Bedruckstoff B, z. B. als bahn- oder bevorzugt bogenförmiger Bedruckstoff B, zuführbar ist, eine ausgangsseitigen Produktaufnahme, durch welche der zumindest einfach bedruckte Bedruckstoff B zu Gebinden, z. B. zu Rollen oder bevorzugt Bogenstapeln, zusammenfassbar ist, und ein dazwischen im Bedruckstoffpfad angeordnetes Druckwerk 04, insbesondere Nummerierdruckwerk 04, durch welches beispielsweise in Reihen und Spalten auf dem Bedruckstoff B vorgesehene Wertpapiernutzen mit mehrstelligen Zeichenfolgen gekennzeichnet, d. h. "nummeriert" werden können.

Dabei umfasst das Druckwerk 04 beispielsweise einen Druckwerkszylinder 06, z. B. Nummerierzylinder 06, welcher im Bereich seines Umfang matrixartig hintereinander mehrere Reihen mit jeweils mehreren nebeneinander angeordneten Kennzeichnungsvorrichtungen 01 trägt, sowie einen den Bedruckstoff B beim Bedrucken abstützenden Druckwerkszylinder 07. Für den Fall bogenförmigen Bedruckstoff B dient dieser Druckwerkszylinder 07, z. B. Gegendruckzylinder 07, beispielsweise gleichzeitig dem Bogentransport und umfass an seinem Umfang eine oder mehrere Halteeinrichtungen 08, z. B. Greiferleisten 08. Die Druckwerkszylinder 06; 07 sind z. B. rotierbar in Gestellwänden eines Gestells 09 gelagert.

Mittels der Kennzeichnungsvorrichtungen 01 sind jeweils Druckbilder von mehrstelligen Zeichenfolgen im Direktdruck unmittelbar oder ggf. über wenigstens einen weiteren Druckwerkszylinder mittelbar auf den Bedruckstoff B aufbringbar. Die Kennzeichnungsvorrichtungen 01 können baulich mit ihren Gestellen 03 in den Druckwerkszylinder 06 integriert sein. Vorzugsweise sind sie jedoch lösbar am Umfang eines Zylinderkörpers angeordnet und in einer bevorzugten Weiterbildung zumindest in Umfangsrichtung am Zylinderkörper variabel positionierbar.

Im Folgenden werden - grundsätzlich unabhängig von oben dargelegter Anwendung in einem obigen Nummerierdruckwerk 04 und/oder einer Wertpapierdruckmaschine, bevorzugt jedoch in Verbindung mit einem solchen bzw. einer solchen - bevorzugte Ausführungen, Weiterbildungen und Ausführungsvarianten für eine solche Kennzeichnungsvorrichtung 01 dargelegt.

In bevorzugter Ausführung sind mehrere, insbesondere sämtliche der p Nummerierräder 02 mechanisch voneinander unabhängig über Antriebsmittel motorisch antreibbar. Grundsätzlich können für die mechanisch voneinander unabhängig antreibbaren Nummerierräder 02 geeignete Antriebsmotoren 12 beliebiger Ausführungsform vorgesehen sein. In hier zu bevorzugender Ausführung ist der jeweilige, ein Nummerierrad 02 mechanisch unabhängig von anderen Nummerierrädern 02 um die Achse 11 rotierende Antriebsmotor 12 jedoch als Schrittmotor 12 ausgebildet. Der Schrittmotor 12 ist beispielsweise mit zwei Phasen ausgeführt und/oder weist z. B. eine Anzahl motorinterner Schritte von 15 bis 25, bevorzugt von 20 Schritten je Umdrehung auf. Um eine gute Positioniergenauigkeit zu gewährleisten ist der Schrittmotor 12 mit einem Haltemoment (bestromt) von wenigstens 1,2 mNm, bevorzugt mindestens 1,5 mNm ausgeführt.

Um beispielsweise ein hohes Maß an Winkelgenauigkeit für das Nummerierrad 02 und/oder Steigerung des Verdrehwiderstandes zu erreichen, umfasst der Antriebsstrang zwischen dem Motorrotor und dem Nummerierrad 02 bevorzugt ein ein- oder mehrstufiges Untersetzungsgetriebe mit einem resultierenden Untersetzungsverhältnis von wenigstens 15 (Rotorumdrehungen) : 1 (Nummerierradumdrehung), insbesondere im Bereich von 15 : 1 bis 25 : 1, beispielsweise von 20 : 1.

Der Antriebsstrang kann in unterschiedlicher geeigneter Weise ausgebildet sein, um vom Antriebsmotor 12 auf das zugeordnete Nummerierrad 02 abzutreiben und beispielsweise o. g. Untersetzung zu realisieren. In einer hier nicht dargestellten Ausführungsvariante umfasst der Antriebsstrang z. B. ein dem Antriebsmotor 12 am Ausgang direkt zugeordnetes Vorsatzgetriebe, z. B. Planetengetriebe, mit abtriebsseitigem Ritzel 14. Zwischen dem am Antriebsmotor 12 oder ggf. am Vorsatzgetriebe sitzenden Ritzel 14 und einem dem Nummerierrad 02 zugeordneten und mit diesem drehfest um eine selbe Rotationsachse drehendes Zahnrad 21, z. B. Antriebsrad 21, ist ein Getriebe mit einer oder mehreren Zahnradstufen vorgesehen. Beispielsweise ist eine erste Getriebestufe durch das Ritzel 14 und ein mit diesem kämmenden Zahnrad 16, z.B. Zwischenzahnrad 16, vorgesehen, wobei letzteres in einer zweiten Getriebestufe auf ein demgegenüber größeres Zahnrad 17, z. B. Stirnrad 17, treibt, das auf gemeinsamen Welle 18 drehfest angeordnet ist mit einem weiteren Zahnrad 19 in einer dritten Getriebestufe auf das demgegenüber größere Antriebsrad 21 treibt.

Die Antriebsmotoren 12 können flächig auf Halterungen 13, z. B. Sockeln 13, aufliegend angeordnet sein, um beispielsweise über den Kontakt beim Betrieb entstehende Wärme abzuleiten.

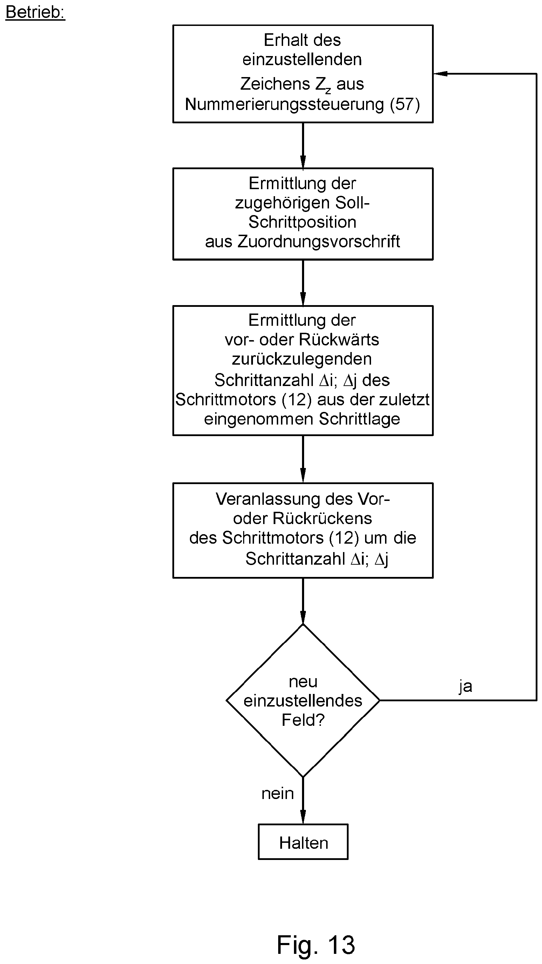

Zur Steuerung des Antriebsmotors 12, insbesondere Schrittmotors 12, steht dieser bzw. dessen motorinterne Steuerung in Signalverbindung zu hier nicht dargestellten Datenverarbeitungs- und/oder Speichermitteln einer Steuerungseinrichtung 22, in welchen eine Zuordnungsvorschrift V zwischen den Arbeitspositionen der alphanummerische Zeichen $Z_Z$ und Schrittzahlen des Schrittmotors 12 vorgehalten ist. Die Zuordnungsvorschrift V kann hierbei tabellarisch oder in Art eines Funktionellen Zusammenhanges vorgehalten, insbesondere gespeichert sein. Im Betrieb wird bzw. ist der Antriebsmotor 12 zum Verbringen eines mittels des Nummerierrades 02 zu druckenden Zeichens $Z_Z$ in eine Arbeitsposition, in der sich das betreffende Zeichen $Z_Z$ in der für den Druck vorgesehen Lage befindet, durch die Steuerungseinrichtung 22 bzw. eine in dieser implementierte Steuerroutine unter Anwendung der vorgehaltenen Zuordnungsvorschrift V hinsichtlich einer, insbesondere für einer Überführung des als nächstes zu druckenden alphanummerische Zeichen $Z_Z$ bzw. des betreffenden Feldes $F_f$ in eine Arbeitsposition, durch den Schrittmotor 12 zurückzulegende Schrittanzahl $\Delta i$; $\Delta j$ , gesteuert bzw. steuerbar. So ist bzw. wird beispielsweise ausgehend von einer bestimmten, insbesondere aktuell eingenommenen Schrittstellung des Schrittmotors 12 bzw. des Nummerierrades 02 und einer für diese Stellung bekannten Schrittzahl i; j (mit i, j aus {1, 2, ...$i_G$} eine für das nachfolgend einzustellende Zeichen $Z_Z$ bzw. Feld $F_f$ anhand der Zuordnungsvorschrift V eine für dieses Zeichen $Z_Z$ bzw. Feld $F_f$ relevante Schrittzahl i'; j" (mit i", j" aus {1, 2, ...$i_G$}) bestimmt und aus der Differenz eine durch den Schrittmotor 12 zurückzulegende Schrittanzahl $\Delta i$; $\Delta j$ ermittelt, wobei dabei auch eine Auswertung des Abstandes dahingehend berücksichtigt ist oder erfolgen kann, in welche Richtung die neue Schrittzahl i'; j' am schnellsten erreichbar ist. Der Antriebsmotor 12 ist bzw. wird dann entsprechend der ermittelten Schrittanzahl $\Delta i$; $\Delta j$ - ggf. unter Berücksichtigung der Drehrichtung R - angesteuert. Solange kein erneuter Wechsel des zu druckenden Zeichens $Z_Z$ bzw. einzustellenden Feldes $F_f$ ansteht, wird die Position des Schrittmotors 12 - ggf. unter Anliegen eines Haltestroms oder durch ein untern erläutertes Verriegelungsmittel 31 - gehalten. Sobald ein erneuter Wechsel des zu druckenden Zeichens Zz bzw. in Arbeitsposition zu verbringenden Feldes Fr ansteht, wiederholt sich der Vorgang für das Einstellen der neuen Nummerierraddrehlage (siehe z. B. Fig. 13). Die Steuereinrichtung bzw. die von der Steuereinrichtung 22 umfasste und/oder in dieser implementierte Steuerroutine ist dementsprechend dazu ausgeführt, ausgehend von einer bestimmten bzw. aktuellen Schrittstellung des Schrittmotors 12 bzw. des Nummerierrades 02 und einer für diese Stellung bekannten Schrittzahl i; j (mit i, j aus {1, 2, ...$i_G$} eine für das nachfolgend einzustellende Zeichen $Z_Z$ bzw. Feld $F_f$ anhand der Zuordnungsvorschrift V eine für dieses Zeichen $Z_Z$ bzw. Feld $F_f$ relevante Schrittzahl i'; j' (mit i", j" aus {1, 2, ...$i_G$}) zu bestimmen, aus der Differenz eine durch den Schrittmotor 12 zurückzulegende Schrittanzahl $\Delta i$; $\Delta j$ zu ermitteln, und den Antriebsmotor 12 entsprechend der ermittelten Schrittanzahl anzusteuern. In vorteilhafter Ausführung ist sie des weiteren dazu ausgebildet, den Abstandes dahingehend auszuwerten, in welche Richtung die neue Schrittzahl i'; j' am schnellsten erreichbar ist und en Antriebsmotor dann unter Berücksichtigung dieser Drehrichtung R anzusteuern.

In der Zuordnungsvorschrift V können den Schrittzahlen i; j die Arbeitspositionen der alphanummerischen Zeichen $Z_Z$ und ggf. Leer- und/oder Fehlerzeichen $Z_⌴$; $Z_X$ direkt selbst zugeordnet sein oder aber die am Nummerierrad 02 für die Zeichen $Z_Z$; $Z_⌴$; $Z_X$ vorgesehenen Felder Fr. Bei letzterem ist z. B. zusätzlich eine Zuordnungsvorschrift V zwischen dem beispielsweise durch eine Nummerierungssteuerung 57 vorgegebenes alphanumerisches Zeichen $Z_Z$ und dem betroffenen Feld $F_f$ vorgehalten. Die Abfolge der Zeichen $Z_Z$ bzw. mehrstelligen Zeichenfolgen für die mindestens eine Nummeriervorrichtung 01 wird beispielsweise durch eine übergeordnete Nummerierungssteuerung 57 z. B. über entsprechende Nummeriervorschriften generiert und vorgegeben.

Die Zuordnungsvorschrift V kann grundsätzlich unter Verwendung eines beliebigen Sensorsystems in einem Referenzlauf ermittelt werden, durch welches ein die Arbeitspositionen der einzustellenden Zeichen $Z_Z$ bzw. Feld $F_f$ betreffendes Signal ermittelbar ist und mit einem für diese Arbeitsposition vorliegenden absoluten oder relativen Schritt einer bestimmten Schrittzahl verknüpfbar ist. Dabei werden beispielsweise die Gesamtzahl der für eine Umdrehung des Nummerierrades 02 erforderlichen Motorschritte $i_G$ durchfahren, durch wenigstens einen Sensor 23; 23.1; 23.2 der Sensoreinrichtung zu den Arbeitspositionen der Zeichen Zz bzw. Felder $F_f$ gehörige sensorspezifische Marken $M_{m,r}$ erfasst, die bei jeweiliger Erfassung der Marke $M_m$ ggf. nach einer weiteren Auswertung und/oder Skalierung bzw. Normierung sich ergebende korrespondierende Schrittzahl i; j registriert und als zu einem Zeichen Zz bzw. Feld $F_f$ zugehörig abgelegt wird. Grundsätzlich können die Marken $M_m$ bzw. deren durch das Sensorsystem lesbare Informationsinhalt eine das jeweilige Feld $F_f$ oder Zeichen $Z_Z$ eindeutig und absolut kennzeichnende Information umfassen. Damit wäre dann eine direkte Zuordnung zwischen dem Zeichen $Z_Z$ bzw. Feld $F_f$ und dem für die Arbeitsposition relevante Schrittzahl i; j bereitgestellt. In hier dargestellter, hinsichtlich der Ausprägung des Markensystems weniger aufwändigen Ausführung ist neben den die jeweiligen Arbeitsposition der Zeichen $Z_Z$ bzw. Felder $F_f$ repräsentierenden Marken $M_m$ eine der Referenz dienende Marke $M_{m,r}$, kurz Referenzmarke $M_{m,r}$, zugeordnet, welche durch ihre Relativlage eine bestimmte eindeutige Lage des Nummerierrades 02 kennzeichnet und hierdurch die relative Lage der einzelnen Zeichen $Z_Z$ bzw. Felder Fr festlegt. Der Vorgang des Detektierens von Marken $M_m$; $M_{m,r}$ und der Zuordnung einer Schrittzahl $i_m$; $i_r$ erfolgt zumindest solange, bis die Marken $M_m$ sämtlicher Zeichen $Z_Z$ bzw. Felder $F_f$ - ggf. samt Referenzmarke $M_{m,r}$ - durchschritten sind, bevorzugt jedoch mindestens für eine volle Umdrehung des Nummerierrades 02.

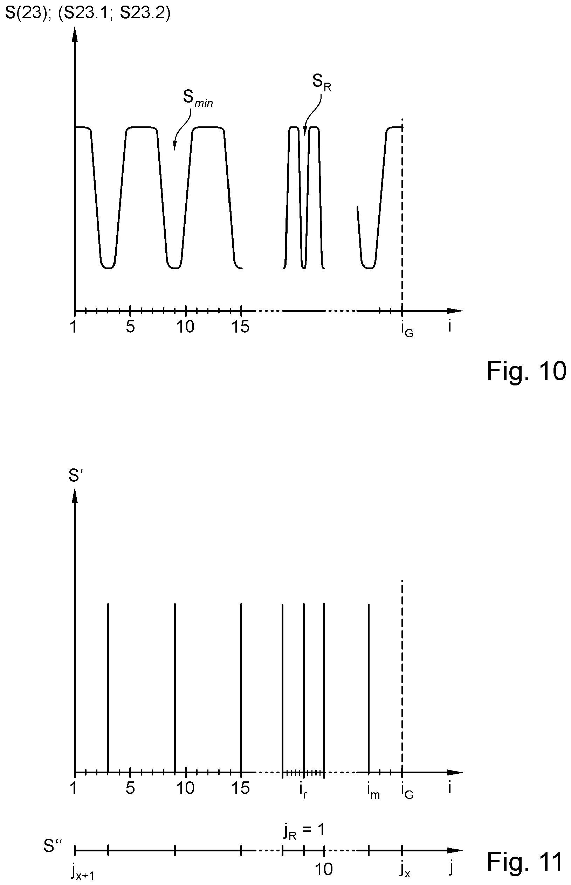

In hier bevorzugter Ausführung (siehe z. B. die rein qualitativen Darstellung in Fig. 10 und Fig. 11) wird der sich bei einer Umdrehung des Nummerierrades 02 ergebende Signalverlauf S(23); S(23.1); S(23.2) am Ausgang des mindestens einen Sensors 23; 23.1; 23.2 abgegriffen. Je nach Ausprägung der Marken $M_m$; $M_{m,r}$ ergeben sich beispielsweise für die Markendurchgänge typische Charakteristika, z. B. Maxima oder Minima $S_{min}$, im gegen die durchschrittenen Schrittzahlen i des Antriebsmotors 12 aufgetragenen Signalverlauf S(23); S(23.1); S(23.2), wenn der Sensor 23; 23.1; 23.2 gerade von einer Marken $M_m$; $M_{m,r}$ des sich drehenden Nummerierrades 02 passiert wird. Im hier beispielhaft dargestellten Beispiel sind dies Minima $S_{min}$, die grundsätzlich ohne weiteres feststellbar sind. Eine präzise Feststellung der Lage der Charakteristika, z. B. Minima $S_{min}$, kann beispielsweise rechnerisch durch passende Frequenzfilter und/oder Flankenauswertungen erfolgen. Die ermittelten Werte für die in den Minima $S_{min}$ vorliegenden Schrittzahlen i können nun unter Berücksichtigung der Lage des aufgrund der Signalform und/oder -abfolge identifizierbaren Referenzsignals $S_R$ den einzelnen Feldern $F_f$ oder Zeichen $Z_Z$; $Z_⌴$; $Z_X$ zugeordnet werden (siehe z. B. exemplarisch eine Signalzuordnung S' nach Auswertung des Signalverlaufs S(23); S(23.1); S(23.2) in Fig. 11) und die Grundlage einer tabellarische Zuordnungsvorschrift V oder Stützstellen einer rechnerischen Zuordnungsvorschrift V bilden. Je nachdem, ob der Referierungslauf in einer beliebigen Nummerierradlage begonnen wurde und ob für die weitere Verwendung eine an der Referenzmarke $M_{m,r}$ mit einer Schrittzahl i = 1 beginnende Skala vorliegen soll, kann eine Verschiebung der die Schrittzahl i betreffende Achse hin zu einer skalierten Zuordnung zwischen den Marken $M_m$; $M_{m,r}$ und skalierten Schrittzahlen j erfolgen bzw. vorgesehen sein (siehe z. B. exemplarisch eine Signalzuordnung S" nach zusätzlicher Skalierung der ursprünglichen Signalzuordnung S' in Fig. 11). Die Schrittzahl $i_G$ wird dabei z. B. zu einer Schrittzahl ix, während die vormalige Schrittzahl i = 1 zur Schrittzahl $i_{X+1}$ wird. Für den oben angedeuteten Fall einer absoluten Identifizierbarkeit der einzelnen Marken $M_m$ an deren spezifischer Ausprägung können o. g. Schritte im Zusammenhang mit dem Bezug auf das Referenzsignal $S_R$ entfallen. Stattdessen kann dann direkt eine Zuordnung zwischen den einzelnen Feldern $F_f$ oder Zeichen $Z_Z$; $Z_⌴$; $Z_X$ und den originalen oder skalierten Schrittzahlen i; j erfolgen.

Unabhängig davon, ob mit der Eindeutigkeit der Marken $M_m$ oder mit einer Referenzmarke $M_{m,r}$, vorgegangen wird, wird also anhand der über die Marken $M_m$; $M_{m,r}$, bestimmten Arbeitspositionen und zugehörigen Schrittzahlen i die Zuordnungsvorschrift V erstellt, welche beispielsweise in Form einer Tabelle oder eines funktionalen Zusammenhangs erfolgen kann. Liegt die Referenzmarke $M_{m,r}$ nach dem Referenzierungslauf beispielsweise nicht bei Schritt "1", so kann zusätzlich eine Skalierung derart erfolgen, dass die Referenzposition bei Schrittzahl "1" vorliegt.

Im Ergebnis wird somit zur Erstellung der Zuordnungsvorschrift V das Nummerierrad 02 in einer Drehrichtung R, z. B. Betriebsdrehrichtung R, um wenigstens eine volle Umdrehung verdreht, dabei werden den Zeichen $Z_Z$; $Z_\text{\_}$; $Z_X$ oder Feldern $F_f$ am Nummerierrad 02 räumlich fest zugeordnete Marken $M_m$ sowie bevorzugt eine Referenzmarke $M_{m,r}$ durch die Sensoreinrichtung detektiert, diese in einer Zuordnungsvorschrift V einer jeweiligen, durch den Antriebsmotor 12 zurückgelegten Schrittanzahl bzw. erreichten Schrittzahl i zugeordnet und das zur betreffenden Marke $M_m$; $M_{m,r}$ korrespondierende Zeichen Zz oder Feld $F_f$ bzw. die Referenz zugewiesen. Im Betrieb wird diese ursprünglich aufgenommene oder ggf. auf die Referenzlage, d. h. die Lage der Referenzmarke $M_{m,r}$ skalierte Zuordnung zwischen den Zeichen $Z_Z$; $Z_\text{\_}$; $Z_X$ oder Feldern $F_f$ und den zugeordneten Schrittzahlen i; j für das Ansteuern des Schrittmotors 12 beim Anfahren der Arbeitspositionen für die Zeichen $Z_Z$; $Z_\text{\_}$; $Z_X$ bzw. Felder $F_f$ herangezogen. Zusätzlich kann z. B. im Betrieb bei Vorhandensein einer o. g. und/oder unten näher beschriebenen Sensoreinrichtung während des Anfahrens oder bei Erreichen einer für ein Zeichen $Z_Z$; $Z_\text{\_}$; $Z_X$ bzw. Feld Fr vorgegebenen Zielschrittzahl anhand der Signale aus der Sensoreinrichtung eine Überprüfung dahingehend erfolgen, ob und/oder in welcher Güte in der Zielposition eine Marke $M_m$ vorliegt oder nicht.

Grundsätzlich unabhängig zu oben beschriebener Anwendung zum Referenzieren eines dem Antrieb eines Nummerierrades 02 dienenden Schrittmotors 12, jedoch vorteilhafter Weise in Verbindung mit einer solchen, ist im Folgenden eine vorteilhafte Ausführung eines Sensorsystems dargelegt.

Die Sensoreinrichtung umfasst dabei z. B. mindestens je einen im Betrieb gestellfesten Sensor 23 für jedes der Mehrzahl von Nummerierräder 02. Diese Sensoren 23 wirken mit mindestens der Anzahl k der alphanummerische Zeichen $Z_Z$ entsprechenden Anzahl I (

$$ I \in \mathbb{N}, $$

I ≥ k) von für die Wirkungsweise des Sensors 23 spezifischen Marken $M_m$ (mit m aus {1, 2, ...I}) zusammen, die am jeweiligen Nummerierrad 02 in je einer festen Umfangsrelativlage zu je einem am Außenumfang getragenen Zeichen $Z_Z$; $Z_\text{\_}$; $Z_X$ bzw. Felder $F_f$ vorgesehen sind. Die Sensoren 23; 23.1; 23.2 sind im Betrieb bevorzugt achsfest und innerhalb des lichten Querschnitts von die Achse 11 aufnehmenden Öffnungen der Nummerierräder 02 angeordnet, die Marken $M_m$; $M_{m,r}$ sind im Bereich des in der Öffnung verlaufenden Innenumfangs der betreffenden Nummerierräder 02 vorgesehen. Somit wirken die beispielsweise in oder auf der Achse 11 vorgesehenen Sensoren 23 mit durch die Sensoren 23 detektierbaren Marken $M_m$ zusammen, die im Bereich des die Achse 11 umgebenden Innenumfanges der Nummerierräder 02 mit fester Winkellagekorrelation zu einem zugeordneten Zeichen $Z_Z$; $Z_\text{\_}$; $Z_X$ bzw. Feld $F_f$ vorgesehen sind.

Vorzugsweise ist zusätzlich zu den den Zeichen $Z_Z$; $Z_\text{\_}$; $Z_X$ bzw. Feldern $F_f$ zugeordneten Marken $M_m$ eine als Referenz für die Einnahme einer definierten Winkellage dienende Marke $M_{m,r}$, kurz Referenzmarke $M_{m,r}$, vorgesehen.

In bevorzugter Ausführung umfasst die Sensoreinrichtung als Magnetfeldsensoren 23, insbesondere als - bevorzugt lineare - Hall-Sensoren 23, ausgebildeten Sensoren 23 und einen radial weiter innen liegenden Magneten 24, insbesondere Bias-Magneten 24. In einer vorteilhaften Ausführung erstreckt sich der Magnet 24 in axialer Richtung durchgehend über einen Längsabschnitt, welcher den Marken $M_m$; $M_{m,r}$ mehrerer, bevorzugt sämtlicher Nummerierräder 02 gegenüberliegt.

In besonders vorteilhafter Ausführung sind als Marken $M_m$; $M_{m,r}$ Inhomogenitäten in der magnetischen Suszeptibilität und/oder Permeabilität im die Achse 11 umgebenden Innenumfangsbereich der Nummerierräder 02 vorgesehen. Bevorzugt, insbesondere Abweichungen von einem kreis- oder zylinderförmigen Verlauf in der zur Achse 11 hin weisenden Innenumfangsfläche - eines bevorzugt selbst kein Magnetfeld erzeugendes magnetisches Material - vorgesehen. Beispielsweise sind als Marken $M_m$; $M_{m,r}$ Erhebungen $M_m$ ; $M_{m,r}$ oder bevorzugt Vertiefungen $M_m$; $M_{m,r}$ in der ansonsten kreis- oder zylinderförmigen Innenumfangsfläche vorgesehen. Bevorzugter Weise basieren die Wirkungen der Marken $M_m$; $M_{m,r}$ also nicht auf einem von diesen ausgehenden Magnetfeldern, sondern auf einer Änderung bzw. Störung des Magnetfeldes eines durch einen gestellfest, insbesondere achsfest vorgesehenen Magneten 24. Im Gegensatz zu Lösungen aus dem Stand der Technik sind die Marken $M_m$; $M_{m,r}$ also vorzugsweise nicht durch Magnete gegeben, sondern durch ein Magnetfeld beeinflussende Inhomogenitäten.

Auf einem Längsabschnitt a11 der Achse 11 sind z. B. eine Anzahl m (

$$ m \in \mathbb{N}, $$

m > 1), ringförmiger, alphanummerische Zeichen $Z_Z$ tragender, insbesondere einzelmotorisch angetriebener Nummerierräder 02 drehbar gelagert, wobei auf diesem Längsabschnitt a11 eine gerade dieser oder mindestens dieser Anzahl m von - insbesondere einzelmotorisch angetriebenen - Nummerierrädern 02 entsprechende Anzahl n (

$$ n \in \mathbb{N}, $$

n ≥ m) von in Axialrichtung zueinander, insbesondere äquidistant, beabstandet angeordneten Sensoren 23 in oder an der Achse 11 vorgesehen sind.

In einer besonders vorteilhaften Ausführung umfasst die Sensoreinrichtung in Umfangsrichtung der Achse 11 betrachtet hintereinander zwei, insbesondere zwei oder mehr im Sinne von mindestens zwei Sensoren 23.1; 23.2, z. B. Magnetfeldsensoren 23.1; 23.2, insbesondere Hall-Sensoren 23.1; 23.2, die mit den Marken $M_m$; $M_{m,r}$ eines selben Nummerierrades 02 zusammen wirken. Aus dem Signalverlauf S(23.1); S(23.2) der in Umfangsrichtung versetzten Sensoren 23.1; 23.2 (siehe z. B. qualitativ für zwei derartig versetzter Sensoren 23.1; 23.2 dargestellt in Fig. 6) lässt sich die Drehrichtung R des betreffenden Nummerierrades 02 auswerten. Die beiden bzw. zwei der versetzt angeordneten Sensoren 23.1; 23.2 sind um einem Winkel voneinander beabstandet, der kleiner ist als derjenige Winkel zwischen den Marken $M_m$ zweier benachbarter Zeichen $Z_Z$; $Z_⎵$; $Z_X$ bzw. Felder $F_f$. Beispielsweise sind die beiden Sensoren 23.1; 23.2 in Umfangsrichtung betrachtet in einem auf die jeweiligen Zentren bezogenen Abstand $d23_u$ angeordnet, dessen Länge auf der die Hüllkreislinie der Achse 11 fortsetzenden Linie z. B. höchstens 10 mm, bevorzugt höchstens 5 mm, insbesondere höchstens 2 mm beträgt.

Zusätzlich hierzu oder stattdessen sind auf o. g. Längsabschnitt a11 in Axialrichtung nebeneinander eine gegenüber der Anzahl m von drehbaren, alphanummerische Zeichen $Z_Z$; $Z_⎵$; $Z_X$ tragenden Nummerierrädern 02 größere, insbesondere mindestens doppelte, Anzahl n (

$$n \in \mathbb{N},$$

n > 2) von in Axialrichtung zueinander, insbesondere äquidistant, beabstandet angeordneten Sensoren 23; 23.1; 23.2 vorgesehen. Beispielsweise sind eine Vielzahl (z. B. eine Anzahl n von mindestens 25, bevorzugt mindestens 50) Sensoren 23; 23.1; 23.2 nebeneinander derart angeordnet, dass deren auf die jeweiligen Zentren bezogene Abstand $d23_a$ z. B. weniger als 5 mm, bevorzugt weniger als 2 mm, insbesondere höchstens 1 mm beträgt. Damit ist eine Auswertung mehrerer nebeneinander angeordneter Sensoren 23; 23.1; 23.2 je Nummerierrad 02 möglich und/oder die Bestückung der Kennzeichnungsvorrichtung 01 mit Nummerierrädern 02 variierender Breite und/oder Anzahl. Für letzteres ist aufgrund des gegenüber der Nummerierradbreite geringeren Abstandes $d23_a$ gewährleistet, dass bei in gewissen Grenzen variierender Breite der zu einzusetzenden Nummerierräder 02 immer wenigstens einer der axial nebeneinander angeordneten Sensoren 23; 23.1; 23.2 mit den Marken $M_m$; $M_{m,r}$ eines Nummerierrades 02 wechselwirkt. Dabei kann bei Initialisierung des Systems aus Kennzeichnungsvorrichtung 01, der zugehörigen Sensoreinrichtung und Auswerteroutine jedem Nummerierrad 02 ein fester Sensor 23; 23.1; 23.2 zugewiesen werden oder aber es werden mehrere in der Flucht des betreffenden Nummerierrades 02 liegende Sensoren 23; 23.1; 23.2 zugewiesen und nach festen Regeln kombiniert ausgewertet.

Die Vielzahl von nebeneinander und ggf. paarweise hintereinander vorgesehenen Sensoren 23; 23.1; 23.2 können bevorzugt - beispielsweise in Art eines Arrays mit zwei Zeilen und eine o. g. Vielzahl von Spalten - auf einem Trägerelement 26 angeordnet sein, mit welchem die Achse 11 bzw. eine dort vorgesehene Ausnehmung 27 als Ganzes bestückbar ist. Ein derartiges Trägerelement 26 kann als mit den Sensoren 23; 23.1; 23.2 bestückte Trägerplatine 26 ausgeführt sein, auf deren Rückseite beispielsweise Leiterbahnen für die Signalübertragung zu einer Seite hin verlaufen können. Von dort können die Signale z. B. über flexible Signalleitungen einer Auswerteroutine zuleitbar sein, die in der o. g. Steuerungseinrichtung 22 oder einem eigens vorgesehenen Auswertemittel 28, z. B. einem entsprechend eingerichtetem Datenverarbeitungs-Chip 28, implementiert ist welcher beispielsweise von der Sensoreinrichtung, insbesondere deren Reihe oder Array von Sensoren 23; 23.1; 23.2, zugeordneten Datenverarbeitungsmittel 29, z. B. einer Signalverarbeitungseinrichtung 29 umfasst ist.

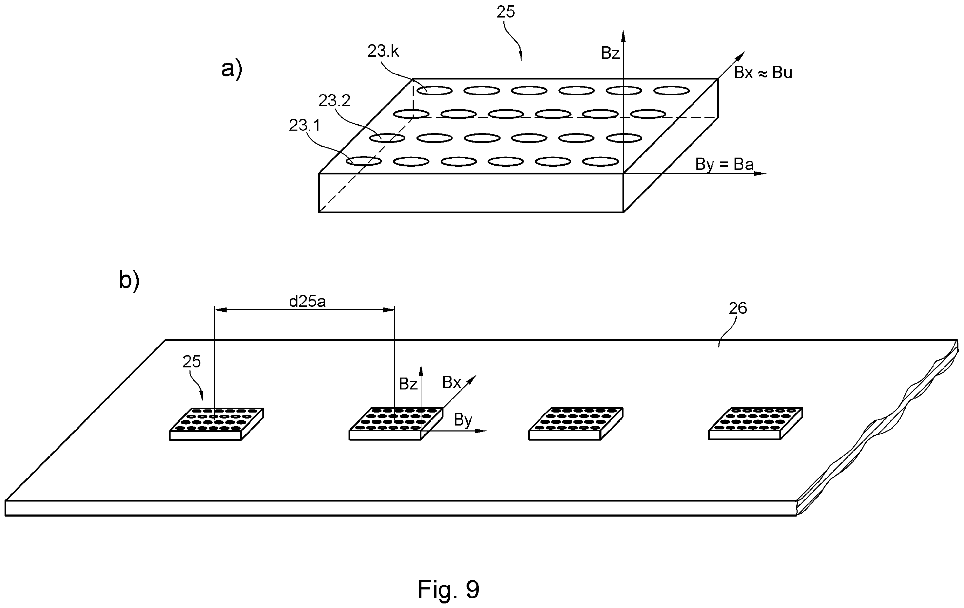

In einer vorteilhaften Ausführung sind anstelle o. g. Paare von Sensoren 23.1; 23.2 ein- oder zwei dimensionale Gruppen 25 von Sensoren 23; 23.1; 23.2, 23.k (k = 3, 4, 5...), insbesondere Hallsensoren 23; 23.1; 23.2, 23.k, z. B. in Art von Sensorarrays 25, vorgesehen, welche dazu ausgebildet sind, z. B. im Falle eines eindimensionalen Sensorarrays 25 zwei bzw. im Fall eines zweidimensionalen Sensorarrays 25 drei magnetische Feldvektorkomponenten Bx, By, Bz eines vorliegenden Magnetfeldes zu liefern (siehe z. B. Fig. 9). Dabei ist die Ausrichtung und Anordnung des Sensorarrays 25 bevorzugt derart vorgesehen, dass zwei Feldvektorkomponenten Bx, By, Bz in einer Ebene liegen, die vorzugsweise senkrecht zur Drehachse der Nummerrierräder 02 steht und wobei bevorzugt eine der Feldvektorkomponenten Bx in Umfangs- bzw. am Messort in Tangentialrichtung verläuft und eine der Feldvektorkomponenten Bz in Radialrichtung des Nummerierrades 02. Im Fall dreier magnetischer Feldvektorkomponenten Bx, By, Bz verläuft beispielsweise zusätzlich eine ermittelbare Feldvektorkomponente Bx, By, Bz in Axialrichtung. Die Auswertung letzterer kann beispielsweise helfen, Randeffekte oder Beeinflussung durch benachbarte Nummerrierräder 02 zu eliminieren.

Ein Sensorarray 25 kann dabei beispielsweise mehrere, z. B. zwei oder mehr Sensoren 23; 23.1; 23.2, 23.k in Umfangs- bzw. Tangentialrichtung betrachtet hintereinander aufweisen und ggf. zusätzlich mehrere, z. B. zwei oder mehr Sensoren 23; 23.1; 23.2, 23.k in Axialrichtung nebeneinander. Die Sensoren 23; 23.1; 23.2, 23.k eines Sensorarrays 25 können in einem Bauteil, z. B. auf einer Platine oder einem IC-Baustein, zusammengefasst sein. Beispielsweise kann ein Sensorarray 25 mehr als sechs. Insbesondere mehr als zehn Sensoren 23; 23.1; 23.2, 23.k umfassen.

Es sind in Axialrichtung nebeneinander eine der Anzahl der Nummerierräder 02 entsprechende oder in obiger Weise demgegenüber höhere Anzahl derartiger Gruppen 25 nebeneinander vorgesehen. Diese können in einer achsparallelen Reihe auf beispielsweise einem o. g. Trägerelement 26 vorgesehen sein. In dieser Ausführung bedarf es lediglich einer Reihe, um die Marken $M_m$; $M_{m,r}$ und zusätzlich eine Bewegungsrichtung zu detektieren. In Abwandlung können jedoch auch zwei oder mehr derartiger, in Umfangsrichtung versetzter Reihen vorgesehen sein. Ein auf die jeweiligen Zentren bezogene Abstand $d25_a$ zweier benachbarter Gruppen 25 in Axialrichtung kann hier z. B. weniger als 5 mm, bevorzugt weniger als 2 mm betragen. Ein Abstand $d23_u$ zwischen zwei in Umfangsrichtung versetzten Sensoren 23.1; 23.2, 23.k eines selben Sensorarrays 25 beträgt auch hier z. B. höchstens 10 mm, bevorzugt höchstens 5 mm, insbesondere höchstens 2 mm.

Die Sensoranordnung ist somit bevorzugt mit zwei oder mehr Sensoren 23; 23.1; 23.2, 23.k je einzelmotorisch zu positionierendem Nummerierrad 02 derart ausgebildet, dass durch Auswertung der Signale zweier oder mehr einem Nummerrierrad 02 zugeordneter Sensoren 23; 23.1; 23.2, 23.k neben dem Durchgang einer Marke auch die Bewegungsrichtung, d. h. die Drehrichtung des Nummerierrades 02, herleitbar ist. Dabei können paarweise hintereinander angeordneter Sensoren 23; 23.1; 23.2 oder o. g. Sensorarrays 25 mit einer Mehrzahl von Sensoren 23; 23.1; 23.2, 23.k, 23.k vorgesehen sein. Die Anzahl der Sensorpaare 23.1, 23.2 oder Sensorarrays 25 kann derjenigen der einzelmotorisch zu positionierenden Nummerierräder 02 entsprechen oder in vorteilhafter Weiterbildung wie dargelegt größer sein. Unabhängig von Anordnung und Ausführung ist bevorzugter Weise ein Winkelabstand zwischen den Sensoren 23.1; 23.2 eines in Umfangsrichtung zueinander versetzten Sensorpaares 23.1, 23.2 oder zweier in Umfangsrichtung versetzter Sensoren 23.1; 23.2, 23.k eines selben Sensorarrays 25 kleiner als der Winkelabstand zwischen zwei am Umfang des Nummerierrades 02 aufeinander folgender Zeichen.

Grundsätzlich unabhängig zu oben beschriebener Anwendung zum Referenzieren eines dem Antrieb eines Nummerierrades 02 dienenden Schrittmotors 12 und von o. g. Ausführungen des Sensorsystems, jedoch vorteilhafter Weise in Verbindung mit einer solchen Anwendung und/oder Sensoreinrichtung, ist im Folgenden eine vorteilhafte Ausführung eines Systems zur Sicherung der eingestellten Arbeitsposition eines, mehrerer oder sämtlicher der in der Kennzeichnungsvorrichtung 01 vorgesehenen Nummerierräder 02.

Hierzu umfasst die Kennzeichnungsvorrichtung 01 vorzugsweise ein Verriegelungsmittel 31 zur Sicherung der für das gewählte Zeichen eingenommenen Arbeitsposition, welches durch einen Aktuator 32; 32'; 32" aus einer aktiven Lage, in der er die Arbeitsposition sichert, in eine inaktiven Lage verbringbar ist. Dabei wirkt das Verriegelungsmittel 31 in aktiver Lage vorteilhaft zumindest mit allen alphanumerische Zeichen Zz am Umfang aufweisenden Nummerierrädern 02, vorzugsweise jedoch mit sämtlichen drehbar gelagerten und drehangetriebenen Nummerierrädern 02 zu dessen Lagesicherung zusammen.

Das Verriegelungsmittel 31 kann in Art einer Sperrklinke 31 ausgebildet sein und/oder kann in korrespondierende Eingriffsmittel 44, z. B. in Vertiefungen 44 oder Erhebungen 44 am Außen- oder Innenumfang des jeweiligen Nummerierrades 02 eingreifen.

Das Verriegelungsmittel 31 kann zwar grundsätzlich durch beliebig ausgebildete Aktuatoren 32; 32'; 32" stellbar sein, sofern durch diesen mindestens ein Anoder Abstellen bewirkbar ist. Bevorzugt ist der das Verriegelungsmittel 31 stellende Aktuator 32; 32'; 32" jedoch als elektromechanisch betätigtes Antriebsmittel 32; 32'; 32" ausgebildet ist, welches infolge unterschiedlicher Ansteuerung mit seinem ausgangsseitigen Abtriebselement 33; 33'; 33" wahlweise in mindestens zwei verschiedene, die aktive und die inaktive Lage des Verriegelungsmittels 31 bewirkende definierte Schaltzustände verbringbar ist. D. h., im Gegensatz z. B. zu lediglich einer definierten Kraftrichtung, die beispielsweise entgegen einer Federkraft und ggf. gegen einen Anschlag wirkt, sind hier durch entsprechende Ansteuerung und elektromagnetische Beaufschlagung des Antriebsmittels 32; 32'; 32" mindestens zwei stabile Aktuatorzustände mit voneinander verschiedenen Zuständen für das ausgangsseitige Abtriebselement 33; 33'; 33" bewirkbar. Dabei ist unter einem stabilen Zustand z. B. ein solcher zu verstehen, welcher erst bei Überschreitung einer bzw. einer mechanisch von außen angreifenden, - insbesondere signifikanten - Schwell- oder Haltekraft bzw. Schwell- oder Haltemomentes aus der eingenommenen stabilen Lage verrückbar ist. Dabei kann z. B. eine signifikante Schwell- oder Haltekraft eine Kraft von mindestens 0,5 N, bevorzugt mindestens 0,8 N, bzw. ein signifikantes Schwell- oder Haltemoment bei mindesten 1,0 mNm, bevorzugt mindestens 1,2 mNm liegen.

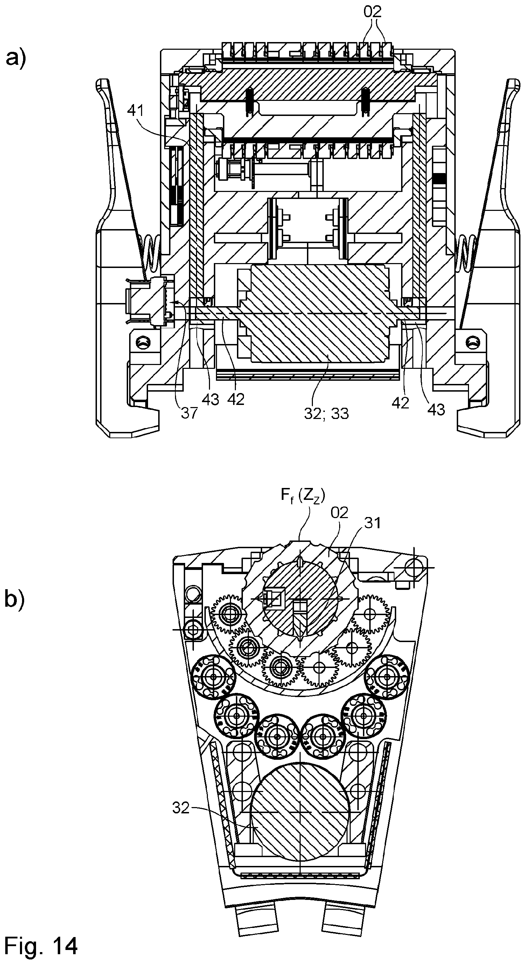

In einer ersten vorteilhaften Ausführungsform (siehe z. B. Fig. 14) ist als Aktuator 32 ein Elektromotor 32 mit einem als Abtriebselement 33 wirksamen Rotor 33, bevorzugt ein Schrittmotor 32, mit definiert anfahrbaren Rotorwinkellagen vorgesehen. Dabei ist im Antriebsstrang zwischen dem Aktuator 32 und dem zu stellenden Verriegelungsmittel 31 ein die Bewegung des rotierenden Abtriebsmittels 33 in eine bevorzugt lineare Stellbewegung des Verriegelungsmittels 31 mit zumindest einer radialen Bewegungskomponente umformendes Getriebe 37, z. B. ausgebildet als Exzentergetriebe 37, vorgesehen. Beispielsweise tragen beidseitig aus dem Elektromotor 32 ragende Wellenenden oder diese verlängernde Wellenstücke 42 jeweils eine Exzenterscheibe 43, welche in Bohrungen eingreifen, die in am Verriegelungsmittel 31 angreifenden Koppeln 41 vorgesehen sind.

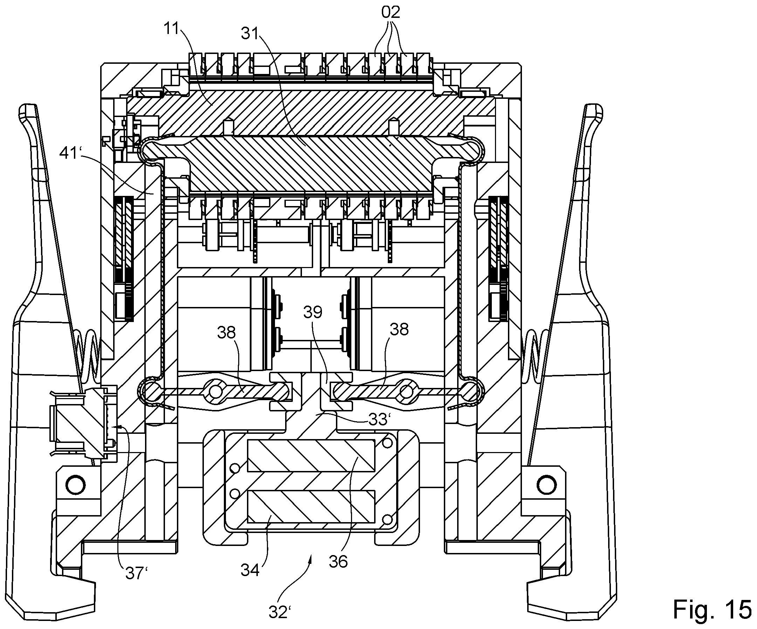

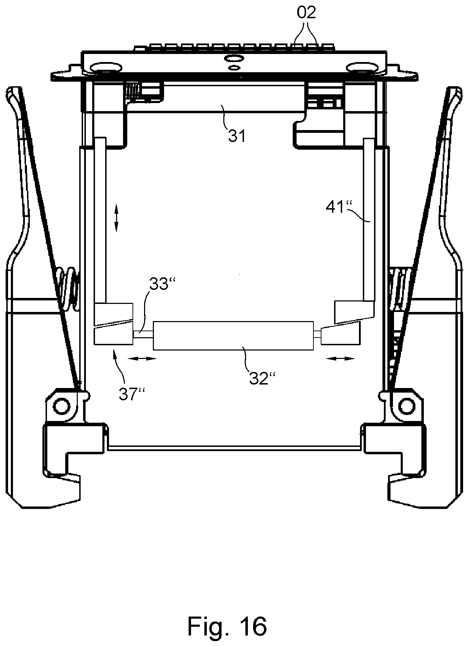

In einer zweiten vorteilhaften Ausführungsform (siehe z. B. Fig. 15 und Fig. 16) ist als Aktuator 32'; 32" ein Linearmotor 32'; 32" mit einem als Abtriebselement 33'; 33" wirksamer Läufer 33'; 33" vorgesehen. Bevorzugter Weise ist er als bidirektional wirksamer Aktuator 32';

32"ausgeführt.

In einer ersten Ausführungsvariante des Linearmotors 32' (siehe z. B. Fig. 15) ist dieser als bi-stabiler Reluktanzmotor 32' ausgeführt. Dabei ist der Läufer 33' durch wechselweises Bestromen zweier in Laufrichtung des Läufers 33' beabstandeter Spulen 34; 36 aktiv in beide Richtungen hin und her bewegbar.

In einer zweiten Ausführungsvariante des Linearmotors 32" (siehe z. B. Fig. 16) ist dieser als linearer Elektromotor 32" mit einem eine Spulenwicklung oder einen Permanentmagneten umfassenden Läufer 33" als Abtriebselement 33" ausgeführt. Je nach Bestromung ist der Läufer 33" linear in die eine oder andere Richtung bewegbar.

Grundsätzlich kann ein o. g. Aktuator 32'; 32" mit seinem als Läufer 33'; 33" ausgebildeten Abtriebselement 33'; 33" direkt oder über einer entsprechenden Verlängerung und ggf. einer Gabelung auf das Verriegelungsmittel 31 zu dessen An- und Abstellung wirken. Auch können zwei derartige, parallel geschaltete lineare Aktuatoren 32'; 32" vorgesehen sein um an beiden Enden des Verriegelungsmittels 31 anzugreifen.

Vorzugsweise ist jedoch im Antriebsstrang zwischen dem jeweiligen linearen Aktuator 32'; 32"und dem zu stellenden Verriegelungselement 31 ein die Bewegung des Abtriebsmittels in eine Bewegung des Verriegelungsmittels 31 umformendes Getriebe 37; 37'; 37" vorgesehen.

Dabei kann - insbesondere für den Fall einer mit zumindest einer radialen Bewegungskomponente verlaufenden Stellrichtung des Abtriebselementes 33' - im Antriebsstrang zwischen dem Abtriebselement 33'; 33" des linearen Aktuators 32'; 32" und dem Verriegelungsmittel 31 ein Hebelgetriebe 37' mit einem - insbesondere zweiarmigen - Hebel 38 vorgesehen sein (siehe z. B. Fig. 15). Ein Ende des Hebels 38 wird durch das Abtriebselement 33'; 33" - beispielsweise mittels eines durch das Abtriebselement 33'; 33" bewegten Mitnehmer 39 oder eine anderweitige Ankopplung - verschwenkt, während an einem zweiten Angriffspunkt, z. B. am anderen Ende - eine am Verriegelungsmittel 31 angelenkte Koppel 41'; 41" angreift. Bevorzugt werden durch das Abtriebselement 33'; 33" über den Mitnehmer 39 oder eine anderweitige Ankopplung und zwei Hebel 38 zwei an den jeweiligen Enden des Verriegelungsmittels 31 angreifende Koppel 41'; 41" bewegt.

In einer anderen Ausführung des Getriebes 37" - insbesondere für den Fall einer senkrecht zur Stellrichtung des Verriegelungsmittels 31 verlaufenden Stellrichtung des Abtriebselementes 33" - kann statt des die beiden Hebel 38 verschwenkenden Mitnehmers 39 ein Getriebe 37", insbesondere ein Keilgetriebe 37", vorgesehen sein, durch welches eine parallel zur Achse 11 verlaufende Bewegung des Abtriebselementes 33'; 33" in eine zumindest mit einer Bewegungskomponente radial zum Nummerierrad 02 verlaufende Stellbewegung umgesetzt wird (siehe z. B. Fig. 16). Abtriebsseitig wirkt das Getriebe 37" auf eine am Verriegelungsmittel 31 angreifende Koppel 41'; 41".

In den Ausführungsbeispielen gemäß Fig. 15 und Fig. 16 können die beiden o. g. Typen von linearen Aktuatoren 32'; 32" auch wechselseitig Anwendung finden.

In sämtlichen Ausführungsvarianten mit linear wirkendem Aktuator 32'; 32" können alternativ zu einem zwei stabile Zustände bereitstellenden Aktuatoren 32'; 32" auch zwei einseitig und entgegengesetzt wirkende Aktuatoren vorgesehen sein, welche wechselseitig aktiviert bzw. deaktiviert werden. Auch hierbei wird eine aktiv herbeigeführte aktive und aktiv herbeigeführte inaktive Lage des Verriegelungsmittels 31 bereitgestellt.

Das Verriegelungsmittel 31 kann, wie oben bereits angedeutet, in Art einer Sperrklinke 31 ausgebildet sein und in zugeordnete Vertiefungen 44 am Außen- oder Innenumfang des jeweiligen Nummerierrades 02 oder zwischen Zähnen eines im Antriebsstrang des betreffenden Nummerierrades 02 vorgesehenen Zahnrades 16; 17; 18; 19; 21 eingreifen. Hierzu sind im Bereich des Außen- oder Innenumfangs des Nummerierrades 02 z. B. mindestens eine der Anzahl k von alphanummerischen Zeichen Zz entsprechende Anzahl von jeweils in einer festen Umfangsrelativlage zu je einem am Außenumfang getragenen Zeichen $Z_Z$ stehende Erhebungen 44 oder Vertiefungen 44 vorgesehen, wobei das Verriegelungsmittel 31 zur Herstellung der Sicherungslage mit einer Vertiefung 44 oder Erhebung 44, insbesondere mit einer Vertiefung 44 oder Erhebung 44 eines vom in Arbeitsposition verbrachten Zeichen $Z_Z$ verschiedenen Zeichens $Z_Z$, in Eingriff verbringbar ist

Grundsätzlich unabhängig zu oben beschriebener Anwendung zum Referenzieren eines dem Antrieb eines Nummerierrades 02 dienenden Schrittmotors 12, von o. g. Ausführungen des Sensorsystems und von der Ausgestaltung des Antriebs für das Verriegelungsmittel 31, jedoch vorteilhafter Weise in Verbindung mit einer solchen Anwendung und/oder Sensoreinrichtung und/oder Antriebsausgestaltung, ist in einer hier bevorzugten Ausführung das Verriegelungsmittel 31 innerhalb der die Achse 11 aufnehmenden lichten Querschnittöffnung des Nummerierrades 02, insbesondere in einer axial verlaufenden Ausnehmung in der Achse 11, angeordnet und greift von innen in Vertiefungen 44 oder Erhebungen 44 in der ansonsten kreis- oder zylinderförmigen Innenumfangsfläche im jeweiligen Nummerierrad 02 ein. Diese Vertiefungen 44 oder Erhebungen 44 sind relativ zum Verriegelungsmittel 31 derart an der Innenumfangsfläche angeordnet, sodass bei Vorliegen der Arbeitslagen zumindest eines jeden anzufahrenden alphanumerischen Zeichens $Z_Z$ das Verriegelungsmittel 31 einer Vertiefung 44 oder Erhebung 44 derart gegenüberliegt, sodass es beim Anstellen in Eingriff mit dieser Vertiefung 44 oder Erhebung 44 verbringbar ist. Vorzugsweise ist der Eingriff in Umfangsrichtung betrachtet spielfrei.

Grundsätzlich kann der das Verriegelungsmittel 31 stellende Aktuator 32; 32'; 32" ebenfalls innerhalb der die Achse 11 aufnehmenden lichten Querschnittöffnung des Nummerierrades 02, insbesondere in einer axial verlaufenden Ausnehmung in der Achse 11, angeordnet sein. Dann können ggf. o. g. Koppel 41; 41'; 41" entfallen. Bevorzugt ist der Aktuator 32; 32'; 32" jedoch radial außerhalb der in Umfangsrichtung verlaufenden Hüllfläche der Nummerierräder 02 angeordnet, wobei die am Verriegelungsmittel 31 angreifenden Koppel 41; 41'; 41" beispielsweise die Gruppe von Nummerierrädern 02 von beiden Stirnseiten her umgreifen.

Ist in einer besonders vorteilhaften Ausführung der Kennzeichnungsvorrichtung 01 eine z. B. oben dargelegte Sensoreinrichtung vorgesehen, welcher mit einer Anzahl von k Vertiefungen 44 oder Erhebungen 44 als Marken $M_m$; $M_{m,r}$ zusammenwirkt, um die Einnahme von Arbeitspositionen jeweils zugeordneter Zeichen nachzuweisen, können zumindest die den alphanummerischen Zeichen $Z_Z$ als Marken $M_m$ zugeordneten Vertiefungen 44 oder Erhebungen 44 gleichzeitig dem Verriegelungsmittel 31 als Eingriffsmittel 44 dienen. Für die Ausführung und Handhabung bzw. Wirkungsweise und Anwendung der Sensoreinrichtung und/oder des als Schrittmotor 12 ausgebildeten Antriebsmotors 12 ist dann vorzugsweise o. g. anzuwenden.

Insbesondere, jedoch nicht nur im letztgenannten Fall, dass die Marken $M_m$ gleichzeitig auch dem Verriegelungsmittel 31 als Eingriffsmittel 44 dienen bzw. umgekehrt, ist das Verriegelungsmittel 31 zur Sicherung der Arbeitslage eines Zeichens $Z_Z$ bevorzugt mit einer der Vertiefungen 44 oder Erhebungen 44 in Eingriff verbringbar, welche verschieden ist zu derjenigen, die für das betreffende, in Arbeitsposition verbrachten Zeichen $Z_Z$ der Sensoreinrichtung als korrespondierende Marke $M_m$ dient.

Grundsätzlich unabhängig zu oben beschriebener Anwendung zum Referenzieren eines dem Antrieb eines Nummerierrades 02 dienenden Schrittmotors 12, von o. g. Ausführungen des Sensorsystems, von der Ausgestaltung des Antriebs für das Verriegelungsmittel 31 oder einer Kombination daraus, jedoch vorteilhafter Weise in Verbindung mit einer solchen Anwendung und/oder Sensoreinrichtung und/oder Antriebsausgestaltung, ist ein verschleißarmes System zur Übertragung der Versorgungsleistung für den Betrieb der Antriebsmotoren 12, der Aktuatoren 32; 32'; 32" und der am Nummerierzylinder 06 mitgeführten Elektronik sowie zur Übertragung von die Vorgaben zur Nummerierung betreffenden Steuerungssignalen vorgesehen.

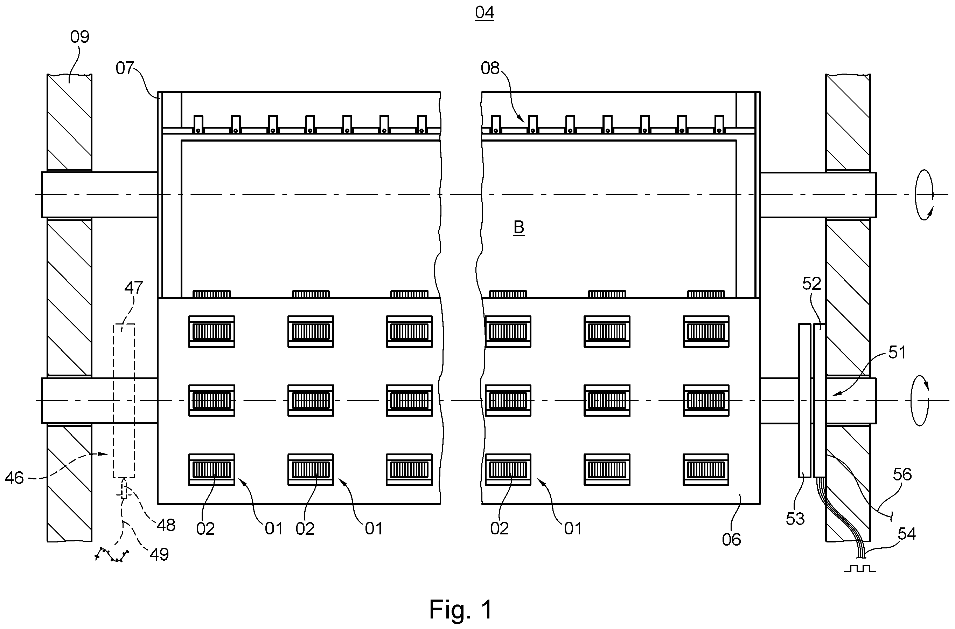

In einer ersten vorteilhaften Ausführung ist dem die Nummeriervorrichtungen 01 tragenden Druckwerkszylinder 06 ein Schleifringsystem 46 mit einem zylinderfesten Schleifring 47 und einem maschinenfesten Schleifkontakt 48 zur Übertragung von elektrischen Leistung vorgesehen, wobei ein maschinenseitiger Modulator zur Modulation des der Leistungsversorgung dienenden Wechselspannungssignals mit Datensignalen, die Informationen zu an den Kennzeichnungsvorrichtungen 01 einzustellende Zeichen $Z_Z$ betreffen vorgesehen ist, sowie ein zylinderfesten Demodulator, durch welchen die Datensignale aus dem modulierten Signal der Leistungsversorgung wieder separierbar sind (siehe z. B. in Fig. 1 exemplarisch auf der linken Seite strichliert angedeutet). Hierdurch wird lediglich ein Schleifringsystem 46 mit lediglich einem Schleifring 47 benötigt, über welches bzw. welchen ohne zusätzliche Spuren Energie und Daten über eine gemeinsame Zuleitung 49 übertragen werden können.

In einer zweiten, bzgl. des Verschleißes noch günstigeren Ausführung, ist dem die Nummeriervorrichtungen 01 tragenden Druckwerkszylinder 06 ein Übertrager 51 zur berührungslosen Übertragung von elektrischer Energie für den Betrieb der Antriebsmotoren 12 und/oder von die an den Nummeriervorrichtungen 01 einzustellenden Zeichen $Z_Z$ bzw. Zeichenfolgen betreffenden Datensignalen zugeordnet, welcher einen gestellfesten Übertragerteil 52 und einen im Betrieb zylinderfesten Übertragerteil 53 umfasst. Dem gestellfesten Übertragerteil 52 werden dabei z. B. elektrische Leistung und Datensignale in getrennten Zuleitungen 54; 56 zugeführt. Die berührungslose Übertragung kann dann intern über zwei verschiedene Kanäle, oder aber über das Wechselspannungssignal mit aufmoduliertem Datensignal über einen selben Kanal erfolgen.

Bezugszeichenliste

| 01 | Vorrichtung zur alphanumerischen Kennzeichnung, Kennzeichnungsvorrichtung, Nummeriervorrichtung |
| 02 | Kennzeichnungswerkzeug, Nummerierrad |
| 03 | Gestell, Gehäuse |
| 04 | Druckwerk, Nummerierdruckwerk |
| 05 | - |
| 06 | Druckwerkszylinder, Nummerierzylinder |
| 07 | Druckwerkszylinder, Gegendruckzylinder |
| 08 | Halteeinrichtung, Greiferleiste |
| 09 | Gestell |
| 10 | - |
| 11 | Achse |
| 12 | Antriebsmotor, Schrittmotor |
| 13 | Halterung, Sockel |
| 14 | Ritzel |
| 15 | - |
| 16 | Zahnrad, Zwischenzahnrad |
| 17 | Zahnrad, Stirnrad |
| 18 | Welle |
| 19 | Zahnrad |
| 20 | - |
| 21 | Zahnrad, Antriebsrad |
| 22 | Steuerungseinrichtung |
| 23 | Sensor, Magnetfeldsensor, Hall-Sensor |
| 23.1 | Sensor, Magnetfeldsensor, Hall-Sensor |
| 23.2 | Sensor, Magnetfeldsensor, Hall-Sensor |
| 23.k | Sensor, Magnetfeldsensor, Hall-Sensor, mit k = 3, 4, 5, ... |

| 24 | Magnet, Bias-Magnet |
| 25 | Gruppe von Sensoren, Sensorarray |
| 26 | Trägerelement, Trägerplatine |
| 27 | Ausnehmung |
| 28 | Auswertemittel, Datenverarbeitungs-Chip |
| 29 | Datenverarbeitungsmittel, Signalverarbeitungseinrichtung |
| 30 | - |
| 31 | Verriegelungsmittel, Sperrklinke |
| 32 | Aktuator, Antriebsmittel, Elektromotor, Schrittmotor |
| 32' | Aktuator, Antriebsmittel, Linearmotor, Reluktanzmotor |
| 32" | Aktuator, Antriebsmittel, Linearmotor, Elektromotor |
| 33 | Abtriebselement, Rotor |
| 33' | Abtriebselement, Läufer |
| 33" | Abtriebselement, Läufer |
| 34 | Spule |
| 35 | - |
| 36 | Spule |
| 37 | Getriebe, Exzentergetriebe |
| 37' | Getriebe, Hebelgetriebe |
| 37" | Getriebe, Keilgetriebe |
| 38 | Hebel |
| 39 | Mitnehmer |
| 40 | - |
| 41 | Koppel |
| 41' | Koppel |
| 41" | Koppel |
| 42 | Wellenstück |
| 43 | Exzenterscheibe |
| 44 | Eingriffsmittel, Vertiefung, Erhebung |
| 45 | - |
| 46 | Schleifringsystem |
| 47 | Schleifring |
| 48 | Schleifkontakt |
| 49 | Zuleitung |
| 50 | - |
| 51 | Übertrager, berührungslos |
| 52 | Übertragerteil, gestellfest |
| 53 | Übertragerteil, zylinderfest |
| 54 | Zuleitung |
| 55 | - |
| 56 | Zuleitung |
| 57 | Nummerierungssteuerung |

| B | Bedruckstoff |
| $F_f$ | Feld (f aus {1, 2, ...g}, |

$$g \in \mathbb{N}$$

$$g \geq k)$$

| i | Schrittzahl (12) |
| $i_m$ | Schrittzahl ($M_m$) |
| $i_r$ | Schrittzahl ($M_{m,r}$) |

| $i_G$ | Motorschritt, gesamt, Schrittzahl |
| j | Schrittzahl (12), skaliert |
| $j_m$ | Schrittzahl, skaliert ($M_m$) |
| $j_r$ | Schrittzahl, skaliert ($M_{m,r}$) |
| $j_x$ | Schrittzahl, skaliert |
| $j_{x+1}$ | Schrittzahl, skaliert |
| $M_m$ | Marke, Erhebung, Vertiefung (m aus {1, 2, ...l}, |

$$l \in \mathbb{N},$$

$$l \geq k)$$

| $M_{m,r}$ | Marke, Referenzmarke, Erhebung, Vertiefung |
| R | Drehrichtung, Betriebsdrehrichtung |
| S(23) | Signalverlauf |
| S(23.1) | Signalverlauf |
| S(23.2) | Signalverlauf |
| S" | Signalzuordnung nach Auswertung |
| S" | Signalzuordnung nach zusätzlicher Skalierung |
| $S_R$ | Referenzsignals |
| $S_{min}$ | Minimum im Signalverlauf |
| R | Drehrichtung, Betriebsdrehrichtung |
| $Z_Z$ | Zeichen, alphanumerisches Zeichen ( |

$$k \in \mathbb{N},$$

$$k > 1)$$

| $Z_⌣$ | Zeichen, Leerzeichen |
| $Z_X$ | Zeichen, Fehlerzeichen, (z aus {1, 2, ...k}) |
| V | Zuordnungsvorschrift |

| a11 | Längsabschnitt (11) |
| d23, | Abstand, axial |
| $d23_u$ | Abstand, in Umfangsrichtung |

| $\Delta i$ | Schrittanzahl |
| $\Delta j$ | Schrittanzahl |

**Patentansprüche**

1. Vorrichtung (01) zur alphanumerischen Kennzeichnung von Wertpapieren, umfassend

   - eine in einem Gestell (03) gelagerte Achse (11), um welche eine Mehrzahl von rad- oder ringförmigen, an ihrem Außenumfang hintereinander mehrere, d. h. eine Anzahl k (

$$k \in \mathbb{N},$$

k > 1) alphanummerische Zeichen ($Z_Z$) tragende Kennzeichnungswerkzeuge (02) drehbar gelagert ist,

- Antriebsmittel mit je einem Antriebsmotor (12) für mehrere oder jedes der Mehrzahl von Kennzeichnungswerkzeugen (02), durch welche diese mechanisch unabhängig voneinander um die Achse (11) rotierbar sind,

- und eine Sensoreinrichtung mit mindestens je einem im Betrieb gestellfesten Sensor (23; 23.1; 23.2) für jedes der Mehrzahl von Kennzeichnungswerkzeugen (02), welche jeweils mit mindestens einer der Anzahl k der alphanummerische Zeichen ($Z_Z$) entsprechenden Anzahl l (

$$l \in \mathbb{N},$$

l ≥ k) von für die Wirkungsweise des Sensors (23; 23.1; 23.2) spezifischen Marken ($M_m$; $M_{m,r}$) zusammenwirken, die am jeweiligen Kennzeichnungswerkzeug (02) in je einer festen Umfangsrelativlage zu je einem am Außenumfang getragenen Zeichen ($Z_Z$; $Z_\llcorner$; $Z_X$) vorgesehen sind,

**dadurch gekennzeichnet,**
**dass** die Sensoren (23; 23.1; 23.2) im Betrieb achsfest und innerhalb des lichten Querschnitts von die Achse (11) aufnehmenden Öffnungen der Kennzeichnungswerkzeuge (02) angeordnet und die Marken ($M_m$; $M_{m,r}$) im Bereich des die Öffnung umgebenden Innenumfangs der betreffenden Kennzeichnungswerkzeuge (02) vorgesehen sind, und/oder dass die Sensoreinrichtung in Umfangsrichtung der Achse (11) betrachtet hintereinander zwei Sensoren (23.1; 23.2) umfasst.

2. Vorrichtung nach Anspruch 1, **dadurch gekennzeichnet, dass** die zwei Sensoren (23.1; 23.2) um die Drehachse der Nummerierräder betrachtet innerhalb eines gegenüber dem Winkelabstand zwischen zwei einander nachfolgenden Zeichen ($Z_Z$; $Z_\llcorner$; $Z_X$) kleineren Winkelabstandes vorgesehen sind und/oder von einem Sensorarray (25) umfasst sind, durch welches mindestens zwei in einer Ebene liegende magnetische Feldvektorkomponenten (Bx, By, Bz) eines vorliegenden Magnetfeldes ermittelbar sind.

3. Vorrichtung nach Anspruch 1 oder 2, **dadurch gekennzeichnet, dass** zusätzlich zu den den Zeichen ($Z_Z$; $Z_\llcorner$; $Z_X$) bzw. Feldern ($F_f$) zugeordneten Marken ($M_m$) eine als Referenz für die Einnahme einer definierten Winkellage dienende Marke ($M_{m,r}$), kurz Referenzmarke ($M_{m,r}$), vorgesehen ist.

4. Vorrichtung nach Anspruch 1, 2 oder 3, **dadurch gekennzeichnet, dass** der jeweilige Sensor (23; 23.1; 23.2) als Magnetfeldsensor (23; 23.1; 23.2), insbesondere als bevorzugt linearer Hall-Sensor (23; 23.1; 23.2), ausgebildet ist und/oder die Sensoreinrichtung einen, bevorzugt radial weiter innen liegenden, Magneten (24), insbesondere Bias-Magneten (24), umfasst.

5. Vorrichtung nach Anspruch 1, 2, 3 oder 4, **dadurch gekennzeichnet, dass** als Marke ($M_m$; $M_{m,r}$) eine Inhomogenität in der magnetischen Suszeptibilität und/oder Permeabilität, insbesondere eine Abweichung von einem kreis- oder zylinderförmigen Verlauf, in der zur Achse (11) hin weisenden Innenumfangsfläche eines selbst kein Magnetfeld erzeugendes magnetisches Materials des Kennzeichnungswerkzeug (02) vorgesehen ist.

6. Vorrichtung nach Anspruch 1, 2, 3, 4 oder 5, **dadurch gekennzeichnet, dass** als Marke ($M_m$; $M_{m,r}$) eine Vertiefung ($M_m$; $M_{m,r}$) oder Erhebung ($M_m$; $M_{m,r}$) in der ansonsten kreis- oder zylinderförmigen Innenumfangsfläche des auf der Achse gelagerten Nummerierrades (02) vorgesehen ist.

7. Vorrichtung nach Anspruch 1, 2, 3, 4, 5 oder 6, **dadurch gekennzeichnet, dass** auf einem Längsabschnitt (a11) der Achse (11) eine Mehrzahl, d. h. eine Anzahl p ($p \in \mathbb{N}$, p > 1), ringförmiger, alphanummerische Zeichen ($Z_Z$) tragender Kennzeichnungswerkzeuge (02) drehbar gelagert und eine gerade dieser oder mindestens dieser Anzahl m entsprechende Anzahl n (

$$n \in \mathbb{N},$$

n ≥ m) von in Axialrichtung zueinander, insbesondere äquidistant, beabstandet angeordneten Sensoren (23; 23.1; 23.2) vorgesehen sind.

8. Vorrichtung nach Anspruch 7, **dadurch gekennzeichnet, dass** auf diesem Längsabschnitt (a11) in Axialrichtung nebeneinander eine gegenüber der Anzahl m von drehbaren, alphanummerische Zeichen ($Z_Z$) tragenden Kennzeichnungswerkzeugen (02) größere, insbesondere mindestens doppelte, Anzahl n (

$$n \in \mathbb{N},$$

n > 2) von in Axialrichtung zueinander, insbesondere äquidistant, beabstandet angeordneten Sensoren (23; 23.1; 23.2) vorgesehen sind.

9. Vorrichtung nach Anspruch 1, 2, 3, 4, 5, 6, 7 oder 8, **dadurch gekennzeichnet, dass** ein wahlweise in eine Sicherungslage verbringbares Verriegelungsmittel (31) zur Sicherung der für das gewählte Zeichen ($Z_z$; $Z_⌴$; $Z_X$) bzw. Feld ($F_f$) eingenommenen Arbeitsposition vorgesehen ist, welches mit Vertiefungen (44) oder Erhebungen (44) am Kennzeichnungswerkzeug (02) oder an einem rotierenden Antriebsglied der das Kennzeichnungswerkzeug (02) antreibenden Antriebsmittel zusammen wirkt.

10. Vorrichtung nach Anspruch 9, **dadurch gekennzeichnet, dass** das Verriegelungsmittel (31) mit einer der als Marke ($M_m$; $M_{m,r}$) wirksamen Vertiefungen (44) oder Erhebung (44), insbesondere mit einer Vertiefung (44) oder Erhebung (44) eines vom in Arbeitsposition verbrachten Zeichen ($Z_z$; $Z_⌴$; $Z_X$) bzw. Feld ($F_f$) verschiedenen Zeichens ($Z_z$; $Z_⌴$; $Z_X$) bzw. Feldes ($F_f$), in Eingriff verbringbar ist.

11. Vorrichtung nach Anspruch 9 oder 10, **dadurch gekennzeichnet, dass** ein elektromagnetisch betätigbarer Aktuator (32; 32'; 32") vorgesehen ist, welcher durch entsprechende Beaufschlagung mit elektrischer Energie mit einem ausgangsseitigen Abtriebselement (33; 33'; 33") aktiv in mindestens zwei verschiedene, die Sicherungslage und eine inaktive Lage bewirkende stabile Schaltzustände verbringbar ist.

12. Vorrichtung nach Anspruch 11, **dadurch gekennzeichnet, dass** das Verriegelungsmittel (31) innerhalb der lichten Querschnittöffnung des ringförmigen Kennzeichnungswerkzeuges (02) ist.

13. Vorrichtung nach Anspruch 11 oder 12, **dadurch gekennzeichnet, dass** der elektromagnetisch betätigbare Aktuator (32; 32'; 32") radial außerhalb der in Umfangsrichtung verlaufenden Hüllfläche des Kennzeichnungswerkzeuges (02) angeordnet ist.

14. Wertpapierdruckmaschine mit einer eingangsseitigen Bedruckstoffzufuhr, durch welche der Druckmaschine eingangsseitig der zu bedruckende Bedruckstoff (B) zuführbar ist, und einer ausgangsseitigen Produktaufnahme, durch welche der zumindest einfach bedruckte Bedruckstoff (B) zu Gebinden zusammenfassbar ist, wobei auf dem Bedruckstoffweg zwischen Bedruckstoffzufuhr und Produktaufnahme wenigstens ein Nummerierdruckwerk (04) mit einem Nummerierzylinder (06) vorgesehen ist, welcher auf seinem Umfang matrixartig hintereinander mehrere Reihen mit jeweils mehreren nebeneinander angeordneten Vorrichtungen (01) gemäß einem der Ansprüche 1 bis 13 trägt.

## Claims

1. Device (01) for the alphanumeric labeling of securities, comprising

   - a shaft (11) mounted in a frame (03), around which shaft a plurality of wheel-shaped or ring-shaped labeling tools (02), each carrying multiple, i.e. a number k (

   $$k \in \mathbb{N},$$

   k > 1) of alphanumeric characters ($Z_z$) one behind the other on its outer circumference, are rotatably mounted,
   - drive means, each drive means having one drive motor (12), for multiple or for each of the plurality of labeling tools (02), by which drive means these plurality of labeling tools can be rotated mechanically independently of one another around the shaft (11),
   - and a sensor device having at least one sensor (23; 23.1; 23.2), which is fixed relative to the frame during operation, for each of the plurality of labeling tools (02), the at least one sensor cooperating with at least a number I (

   $$l \in \mathbb{N}$$

   , I ≥ k) of marks ($M_m$; $M_{m,r}$) , corresponding to the number k of alphanumeric characters ($Z_Z$), which marks are specific to the functioning method of the sensor (23; 23.1; 23.2) and are provided on the respective labeling tool (02) each in a fixed circumferential position relative to one character ($Z_z$; $Z_⌴$; $Z_X$) carried on the outer circumference,

   **characterized in that**
   the sensors (23; 23.1; 23.2) are fixed relative to the shaft during operation and are arranged within the clear crosssection of openings in the labeling tools (02) for receiving the shaft (11), and the marks ($M_m$; $M_{m,r}$) are provided in the region of the inner circumference of the relevant labeling tools (02), which surrounds the opening, and/or **in that** the sensor device comprises two sensors (23.1; 23.2) arranged one behind the other as viewed in the circumferential direction of the shaft (11).

2. Device according to claim 1, **characterized in that** the two sensors (23.1; 23.2) are provided within an angular distance smaller than the angular distance between two consecutive characters ($Z_z$; $Z_\lrcorner$; $Z_x$), as viewed around the axis of rotation of the numbering wheels, and/or are comprised by a sensor array (25) by which at least two magnetic field vector components (Bx, By, Bz), lying in one plane, of an existing magnetic field can be determined.

3. Device according to claim 1 or 2, **characterized in that**, in addition to the marks ($M_m$) assigned to the characters ($Z_z$; $Z_\lrcorner$; $Z_X$) or fields ($F_f$), a mark ($M_{m,r}$) which serves as a reference for the assumption of a defined angular position, a reference mark ($M_{m,r}$) for short, is provided.

4. Device according to claim 1, 2 or 3, **characterized in that** the respective sensor (23; 23.1; 23.2) is in the form of a magnetic field sensor (23; 23.1; 23.2), in particular in the form of a preferably linear Hall sensor (23; 23.1; 23.2), and/or the sensor device comprises a magnet (24), in particular a bias magnet (24), which is preferably positioned further inward radially.

5. Device according to claim 1, 2, 3 or 4, **characterized in that** the mark ($M_m$; $M_{m,r}$) is provided in the form of an inhomogeneity in magnetic susceptibility and/or permeability, in particular a deviation from a circular or cylindrical profile, in the inner circumferential surface, facing the shaft (11), of a magnetic material of the labeling tool (02) which does not itself generate a magnetic field.

6. Device according to claim 1, 2, 3, 4 or 5, **characterized in that** the mark ($M_m$; $M_{m,r}$) is provided in the form of an indentation ($M_m$; $M_{m,r}$) or protrusion ($M_m$; $M_{m,r}$) in the otherwise circular or cylindrical inner circumferential surface of the numbering wheel (02) mounted on the shaft.

7. Device according to claim 1, 2, 3, 4, 5 or 6, **characterized in that** on a longitudinal section (a11) of the shaft (11) a plurality, i.e. a number p (

$$p \in \mathbb{N},$$

p > 1), of ring-shaped labeling tools (02) carrying alphanumeric characters ($Z_z$) are rotatably mounted, and a number n (

$$n \in \mathbb{N},$$

n ≥ m), corresponding to precisely or at least this number m, of sensors (23; 23.1; 23.2) are provided spaced, in particular equidistantly, from one another in the axial direction.

8. Device according to claim 7, **characterized in that** a number n (

$$n \in \mathbb{N},$$

n > 2) of sensors (23; 23.1; 23.2) greater than the number m of rotatable labeling tools (02) carrying alphanumeric characters ($Z_z$), in particular at least twice this number, arranged spaced, in particular equidistantly, from one another in the axial direction are provided side by side in the axial direction on this longitudinal section (a11).

9. Device according to claim 1, 2, 3, 4, 5, 6, 7 or 8, **characterized in that** a locking means (31) is provided, which can be moved selectively into a secured position to secure the working position assumed for the selected character ($Z_z$; $Z_\lrcorner$; $Z_X$) or field ($F_f$) and which cooperates with indentations (44) or protrusions (44) on the labeling tool (02) or on a rotating driven member of the drive means that drives the labeling tool (02) .

10. Device according to claim 9, **characterized in that** the locking means (31) can be brought into engagement with one of the indentations (44) or protrusions (44) acting as a mark ($M_m$; $M_{m,r}$), in particular with an indentation (44) or protrusion (44) of a character ($Z_z$; $Z_\lrcorner$; $Z_X$) or field ($F_f$) other than the character ($Z_z$; $Z_\lrcorner$; $Z_X$) or field ($F_f$) that has been moved into the working position.

11. Device according to claim 9 or 10, **characterized in that** an electromagnetically operable actuator (32; 32'; 32") is provided, which electromagnetically operable actuator can be actively moved by an output-side driven element (33; 33'; 33"), through the corresponding application of electric energy, into at least two different stable switching states which bring about the secured position and an inactive position.

12. Device according to claim 11, **characterized in that** the locking means (31) is arranged within the clear crosssectional opening of the ring-shaped labeling tool (02).

13. Device according to claim 11 or 12, **characterized in that** the electromagnetically operable actuator (32; 32'; 32") is located radially outside of the circumferentially extending outer surface of the labeling tool (02).

**14.** Security printing press comprising an input-side printing material feed unit, by which the printing material (B) to be printed can be fed to the printing press on the input side, and an output-side product receiving unit, by which the printing material (B) which has been printed on at least one side can be combined into bundles, wherein at least one numbering printing couple (04) is provided on a printing material path between the printing material feed unit and the product receiving unit, which numbering printing couple has a numbering cylinder (06) that carries on its circumference, in the form of a matrix, multiple rows one behind the other, each row containing multiple devices (01) according to any one of claims 1 to 13 arranged side by side.

**Revendications**

**1.** Dispositif (01) pour l'identification alphanumérique de papiers fiduciaires, comprenant

- un axe (11) monté dans un bâti (03), autour duquel une pluralité d'outils d'identification (02) en forme de roue ou d'anneau, portant sur leur périphérie extérieure les uns derrière les autres plusieurs, c'est-à-dire un nombre k (kE N, k > 1) de caractères alphanumériques ($Z_z$), est montée rotative,
- des moyens d'entraînement avec respectivement un moteur d'entraînement (12) pour plusieurs ou chacun de la pluralité d'outils d'identification (02), par lesquels ceux-ci peuvent être amenés en rotation autour de l'axe (11) mécaniquement indépendamment les uns des autres,
- et un système de capteur avec au moins respectivement un capteur (23 ; 23.1 ; 23.2) fixé au bâti durant l'utilisation pour chacun de la pluralité d'outils d'identification (02), lesquels coopèrent respectivement avec au moins un nombre l (l $\in$ $\mathbb{N}$, l $\geq$ k) de marques ($M_m$ ; $M_{m,r}$) spécifiques au fonctionnement du capteur (23 ; 23.1 ; 23.2) correspondant au nombre k des caractères alphanumériques ($Z_z$), qui sont prévues sur l'outil d'identification (02) respectif dans respectivement une position relative périphérique fixe par rapport à respectivement un caractère ($Z_z$ ; $Z_\_$ ; $Z_x$) porté sur la périphérie extérieure,

**caractérisé en ce que** les capteurs (23 ; 23.1 ; 23.2) durant l'utilisation sont disposés de manière fixée à l'axe et à l'intérieur de la section transversale intérieure d'ouvertures des outils d'identification (02) recevant l'axe (11) et les marques ($M_m$ ; $M_{m,r}$) sont prévues dans la zone de la périphérie intérieure des outils d'identification (02) concernés entourant l'ouverture, et/ou que le système de capteur comprend vu dans la direction périphérique de l'axe (11) deux capteurs (23.1 ; 23.2) l'un derrière l'autre.

**2.** Dispositif selon la revendication 1, **caractérisé en ce que** les deux capteurs (23.1 ; 23.2) sont prévus vus autour de l'axe de rotation des roues de numérotation à l'intérieur d'un espacement angulaire plus petit par rapport à l'espacement angulaire entre deux caractères ($Z_z$ ; $Z_\_$ ; $Z_x$) se succédant et/ou sont entourés par un réseau de capteurs (25), par lequel au moins deux composantes de vecteur de champ magnétique (Bx, By, Bz) d'un champ magnétique présent situés dans un plan peuvent être déterminées.

**3.** Dispositif selon la revendication 1 ou 2, **caractérisé en ce qu'**en plus des marques ($M_m$) associées aux caractères ($Z_z$ ; $Z_\_$ ; $Z_x$) ou champs ($F_f$) une marque ($M_{m,r}$) servant de référence pour l'occupation d'une position angulaire définie, en bref marque de référence ($M_{m,r}$), est prévue.

**4.** Dispositif selon la revendication 1, 2 ou 3, **caractérisé en ce que** le capteur (23 ; 23.1 ; 23.2) respectif est réalisé en tant que capteur de champ magnétique (23 ; 23.1 ; 23.2), en particulier en tant que capteur à effet Hall (23 ; 23.1 ; 23.2) de préférence linéaire, et/ou le système de capteur comprend un aimant (24), en particulier aimant de polarisation (24), de préférence situé radialement plus à l'intérieur.

**5.** Dispositif selon la revendication 1, 2, 3 ou 4, **caractérisé en ce qu'**une inhomogénéité dans la susceptibilité et/ou perméabilité magnétique, en particulier un écart par rapport à un tracé circulaire ou cylindrique, dans la surface périphérique intérieure dirigée vers l'axe (11) d'un matériau magnétique de l'outil d'identification (02) ne produisant luimême pas de champ magnétique, est prévue en tant que marque ($M_m$ ; $M_{m, r}$).

**6.** Dispositif selon la revendication 1, 2, 3, 4 ou 5, **caractérisé en ce qu'**un évidement ($M_m$ ; $M_{m,r}$) ou bossage ($M_m$ ; $M_{m,r}$) dans la surface périphérique intérieure par ailleurs circulaire ou cylindrique de la roue de numérotation (02) montée sur l'axe est prévu en tant que marque ($M_m$ ; $M_{m, r}$).

**7.** Dispositif selon la revendication 1, 2, 3, 4, 5 ou 6, **caractérisé en ce qu'**une pluralité, c'est-à-dire un nombre p (

$$p \in \mathbb{N},$$

p > 1), d'outils d'identification (02) annulaires portant des caractères alphanumériques ($Z_z$) sont montés de manière rotative sur une partie longitudinale (a11) de l'axe (11) et un nombre n (

$$n \in \mathbb{N},$$

n ≥ m) pair de capteurs (23 ; 23.1 ; 23.2) disposés de manière espacée les uns des autres dans la direction axiale, en particulier de manière équidistante, correspondant à celle-ci ou au moins à ce nombre m, sont prévus.

8. Dispositif selon la revendication 7, **caractérisé en ce qu'**un nombre n (

$$n \in \mathbb{N},$$

n > 2) de capteurs (23 ; 23.1 ; 23.2) disposés de manière espacée les uns des autres dans la direction axiale, en particulier de manière équidistante, plus grand, en particulier au moins deux fois, par rapport au nombre m d'outils d'identification (02) rotatifs, portant des caractères alphanumériques ($Z_z$), sont prévus sur cette partie longitudinale (a11) dans la direction axiale.

9. Dispositif selon la revendication 1, 2, 3, 4, 5, 6, 7 ou 8, **caractérisé en ce qu'**un moyen de verrouillage (31) pouvant être amené sélectivement dans une position de blocage pour le blocage de la position de travail occupée pour le caractère ($Z_z$ ; $Z_⌣$ ; $Z_x$) ou champ ($F_f$) sélectionné est prévu, lequel coopère avec les évidements (44) ou bossages (44) sur l'outil d'identification (02) ou sur un élément d'entraînement rotatif des moyens d'entraînement entraînant l'outil d'identification (02).

10. Dispositif selon la revendication 9, **caractérisé en ce que** le moyen de verrouillage (31) peut être amené en prise avec un évidement (44) ou bossage (44) fonctionnant en tant que marque ($M_m$ ; $M_{m,r}$), en particulier avec un évidement (44) ou bossage (44) d'un caractère ($Z_z$ ; $Z_⌣$ ; $Z_x$) ou champ ($F_f$) différent du caractère ($Z_z$ ; $Z_⌣$ ; $Z_x$) ou champ ($F_f$) amené dans la position de travail.

11. Dispositif selon la revendication 9 ou 10, **caractérisé en ce qu'**un actionneur (32 ; 32' ; 32") pouvant être actionné de manière électromagnétique est prévu, lequel peut être amené par une sollicitation correspondante avec de l'énergie électrique avec un élément mené (33 ; 33' ; 33") côté sortie de manière active dans au moins deux états de commutation stables différents, entraînant la position de blocage et une position inactive.

12. Dispositif selon la revendication 11, **caractérisé en ce que** le moyen de verrouillage (31) est à l'intérieur de l'ouverture de section transversale intérieure de l'outil d'identification (02) annulaire.

13. Dispositif selon la revendication 11 ou 12, **caractérisé en ce que** l'actionneur (32 ; 32' ; 32") pouvant être actionné de manière électromagnétique est disposé radialement à l'extérieur de la surface enveloppante de l'outil d'identification (02) s'étendant dans la direction périphérique.

14. Machine d'impression de papier fiduciaire avec une amenée de substrat d'impression côté entrée, par laquelle le substrat d'impression (B) à imprimer peut être amené à la machine d'impression côté entrée, et un logement de produit côté sortie, par lequel le substrat d'impression (B) imprimé au moins une fois peut être regroupé en lots, dans laquelle au moins un groupe d'impression de numérotation (04) avec un cylindre de numérotation (06), lequel porte sur sa périphérie plusieurs rangées les unes derrière les autres en matrice avec respectivement plusieurs dispositifs (01) selon l'une quelconque des revendications 1 à 13 disposés les uns à côté des autres, est prévu sur la voie de substrat d'impression entre l'amenée de substrat d'impression et le logement de produit.

Fig. 1

EP 4 014 053 B1

Fig. 2

EP 4 014 053 B1

Fig. 3

Fig. 4

Fig. 5

Fig. 6

$F_f (Z_{Z'}; Z_X; Z_{\llcorner})$

Fig. 7

EP 4 014 053 B1

Fig. 8

Fig. 9

Fig. 10

Fig. 11

Referenzlauf:

Fig. 12

Betrieb:

```
┌─────────────────────────┐
│      Erhalt des         │
│    einzustellenden      │
│   Zeichens Z_z aus      │
│ Nummerierungssteuerung  │
│          (57)           │
└─────────────────────────┘
            │
            ▼
┌─────────────────────────┐
│     Ermittlung der      │
│   zugehörigen Soll-     │
│     Schrittposition     │
│  aus Zuordnungsvorschrift│
└─────────────────────────┘
            │
            ▼
┌─────────────────────────┐
│     Ermittlung der      │
│   vor- oder Rückwärts   │
│    zurückzulegenden     │
│ Schrittanzahl Δi; Δj des│
│Schrittmotors (12) aus der zuletzt│
│  eingenommen Schrittlage│
└─────────────────────────┘
            │
            ▼
┌─────────────────────────┐
│  Veranlassung des Vor-  │
│    oder Rückrückens     │
│ des Schrittmotors (12) um die│
│   Schrittanzahl Δi; Δj  │
└─────────────────────────┘
            │
            ▼
           neu
      einzustellendes ──── ja ───┐
          Feld?                  │
            │                    │
           nein                  │
            │                    │
            ▼                    │
┌──────────────┐                 │
│    Halten    │                 │
└──────────────┘                 │
```

Fig. 13

Fig. 14

Fig. 15

Fig. 16

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007148288 A2
- ES 2357985 T3
- AU 2013209308 B2
- JP 2004160788 A
- WO 2016000741 A1
- DE 3841231 A1
- GB 2243580 A
- WO 2017157619 A1
- JP 2006224519 A